# EUROPÄISCHE PATENTSCHRIFT

(11) **EP 4 097 042 B1**
(45) Veröffentlichungstag und Bekanntmachung des Hinweises auf die Patenterteilung: **17.09.2025**
(21) Anmeldenummer: 21702213.6
(22) Anmeldetag: 26.01.2021
(51) Int. Cl.: B81C 99/00

(54) **VERFAHREN UND VORRICHTUNGEN ZUM AKUSTISCHEN TESTEN VON MEMS BAUELEMENTEN**
METHOD AND DEVICES FOR ACOUSTICALLY TESTING MEMS COMPONENTS
PROCÉDÉ ET DISPOSITIFS DE TEST ACOUSTIQUE DE COMPOSANTS MEMS

(30) Priorität: 30.01.2020 DE 102020201124
(43) Veröffentlichungstag der Anmeldung: 07.12.2022
(73) Patentinhaber: Fraunhofer-Gesellschaft zur Förderung der angewandten Forschung e.V., 80686 München (DE)
(72) Erfinder: FRITSCH, Tobias, 98693 Ilmenau (DE); CLAUSS, Tobias, 98693 Ilmenau (DE); FRITZSCHE, Paul, 98693 Ilmenau (DE); FIEDLER, Matthias, 98693 Ilmenau (DE)
(74) Vertreter: Schlenker, Julian
(86) Internationale Anmeldenummer: PCT/EP2021/051680
(87) Internationale Veröffentlichungsnummer: WO 2021/151861

(56) Entgegenhaltungen:
- CASSET F ET AL: "A 256 MEMS Membrane Digital Loudspeaker Array Based on PZT Actuators", PROCEDIA ENGINEERING, vol. 120, 6 September 2015 (2015-09-06) - 9 September 2015 (2015-09-09), pages 49 - 52, XP029268308, ISSN: 1877-7058, DOI: 10.1016/J.PROENG.2015.08.563
- LEDESMA EYGLIS ET AL: "ALN Pmut with Crossed-Cavity for Better Acoustic Pressure Outputs in Liquid at High Frequency", 2019 20TH INTERNATIONAL CONFERENCE ON SOLID-STATE SENSORS, ACTUATORS AND MICROSYSTEMS & EUROSENSORS XXXIII (TRANSDUCERS & EUROSENSORS XXXIII), IEEE, 23 June 2019 (2019-06-23), pages 825 - 828, XP033599902, DOI: 10.1109/TRANSDUCERS.2019.8808260

## Beschreibung

Ausführungsbeispiele der vorliegenden Erfindung beziehen sich auf ein Verfahren zum akustischen Testen von zumindest einem MEMS Bauelement (MEMS = Micro-Electro-Mechanical Systems, dt. mikroelektromechanisches System) einer Mehrzahl von MEMS Bauelementen. Weitere Ausführungsbeispiele beziehen sich auf eine Vorrichtung zum akustischen Testen von zumindest einem MEMS Bauelement einer Mehrzahl von MEMS Bauelementen. Manche Ausführungsbeispiele beziehen sich auf ein akustisches Testen von MEMS.

Die Überprüfung von mikroelektromechanischen Systemen (MEMS) auf ihre gewünschte Funktionsweise birgt nicht triviale technische Probleme. So kann ein nachweislich elektrisch voll funktionstüchtiges MEMS mechanisch defekt sein. Auch vice versa ist ein solcher Fall möglich, es ist mechanische Bewegung vorhanden, aber die elektrische Funktionstüchtigkeit ist nicht gegeben, da z. B. ein elektrischer Kurzschluss vorliegt.

Zudem ist eine rein elektrische Messung gegebenenfalls problematisch, da bestimmte MEMS-Strukturen in der gewünschten Funktion nur von sehr kleinen Strömen durchflossen werden und entsprechend hohe Wiederstände/Impedanzen (MOhm-GOhm-Bereich) vorliegen. Das hat zur Folge, dass metrologische Verfahren oft in Zusammenhang mit langen Integrationszeiten stehen. Im Hinblick auf optimierte Produktionslinien erscheinen diese Verfahren als unwirtschaftlich. Ein möglicher Lösungsansatz ist die Prüfung, ob eine elektrische Anregung des MEMS zu einer mechanischen Bewegung führt. Dies kann optisch, welches den Stand der Technik darstellt, durchgeführt werden, welches aber einen großen Aufwand für Messungen an mehr als einem Chip parallel darstellt. Ein Teilproblem stellen hier die zugrunde liegenden Optiken und deren Formfaktoren dar. Auch sind bei sehr kleinen MEMS-Strukturen sehr teure Messapparaturen notwendig, welche aufgrund ihres Funktionsprinzips (z. B. Stroboskop) auch sehr zeitintensiv sein können. Weiterhin können, zum aktuellen Stand der Technik, keine optischen Tests an den innenliegenden Strukturen von eingehausten oder gedeckelten MEMS durchgeführt werden, was zur Folge hat, dass Defekte, die durch das Einhausen/Deckeln entstehen, nicht untersucht werden können. Auch die sich in der aktuellen Forschung befindenden optischen Systeme, welche durch Silizium, ergo durch Einhausungen/Deckeln, Strukturen offenlegen können, sind noch in ihrer Reichweite beschränkt und können folglich größere Chips nicht vollständig untersuchen. Je später ein bereits vorhandener oder im Produktionsprozess eingebrachter Defekt in der Wertschöpfungskette entdeckt wird, um so kostenintensiver wird der gesamte Herstellungsprozess.

In dem Artikel [CASSET FETAL: "A 256 MEMS Membrane Digital Loudspeaker Array Based on PZT Actuators", PROCEDIA ENGINEERING, vol. 120, 6 September 2015 (2015-09-06), - 9 September 2015 (2015-09-09), pages 49-52, XP029268308, ISSN: 1877-7058, DOI: 10.1016/ J.PROENG.2015.08.563] beschreibt einen Aufbau zur Charakterisierung eines MEMS basiertes digitales Lautsprecherarrays. Hierbei wird das Lautsprecherarray mit einem Sinussignal mit einer Frequenz von 500 Hz bis 50 kHz angeregt, während die akustische Schwingung des Lautsprecherarrays mittels eines Mikrofons erfasst werden.

In dem Artikel [LEDESMA EYGLIS ET AL: "ALN Pmut with Crossed-Cavity for Better Acoustic Pressure Outputs in Liquid at High Frequency", 2019 20TH INTERNATIONAL CONFERENCE ON SOLID-STATE SENSORS, ACTUATORS AND MICROSYSTEMS & EUROSENSORS XXXIII (TRANSDUCERS & EUROSENSORS XXXIII), IEEE, 23 June 2019 (2019-06-23), pages 825-828, XP033599902, DOI: 10.1109/ TRANSDUCERS.2019.] beschreibt einen piezoelektrischen, mikromechanischen Ultraschallwandler.

Die US 2010/219839 A1 beschreibt ein Verfahren zum Testen einer kapazitiven Wandlerschaltung, beispielsweise eines kapazitiven MEMS-Wandlers, durch Anlegen eines Testsignals über einen oder mehrere Kondensatoren, die in der Wandlerschaltung vorgesehen sind.

Der vorliegenden Erfindung liegt somit die Aufgabe zugrunde, die bestehende Situation zu verbessern.

Die Erfindung ist in den unabhängigen Ansprüchen angegeben. Entsprechend gehört zur Erfindung ein Verfahren zum akustischen Testen von zumindest einem MEMS Bauelement einer Mehrzahl von MEMS Bauelementen, wobei das Verfahren aufweist: Bereitstellen der Mehrzahl von MEMS Bauelementen mit dem zumindest einen MEMS Bauelement, Bereitstellen einer Testvorrichtung und Kontaktieren des zumindest einen MEMS Bauelements mit der Testvorrichtung, Anregen des zumindest eines MEMS Bauelements zu einer akustischen Schwingung mit der Testvorrichtung, Erfassen der akustischen Schwingung des zumindest einen MEMS Bauelements mit zumindest einem Schallsensor der Testvorrichtung, Auswerten der mit dem zumindest einen Schallsensor erfassten akustischen Schwingung des zumindest einen MEMS Bauelements, um das zumindest eine MEMS Bauelement auf eine Soll-Funktionsfähigkeit hin zu testen, wobei die Testvorrichtung ein Prüfkopf, ein Teil eines Prüfkopfes, oder eine Testkarte ist. Bei Ausführungsbeispielen kann bei dem Bereitstellen des zumindest einen MEMS

Bauelements ein Wafer mit einer Mehrzahl von MEMS Bauelementen bereitgestellt werden, wobei bei dem Anregen des zumindest eines MEMS Bauelements zumindest ein MEMS Bauelement der Mehrzahl von MEMS Bauelementen angeregt werden kann.

Bei Ausführungsbeispielen kann das zumindest eine MEMS Bauelement auf Waferebene vor einer Vereinzelung der Mehrzahl von MEMS Bauelementen getestet werden.

Bei Ausführungsbeispielen kann bei dem Bereitstellen des zumindest einen MEMS Bauelements ein integrierter Schaltkreis oder Chip mit dem zumindest einen MEMS Bauelement bereitgestellt werden.

Bei Ausführungsbeispielen kann das zumindest eine MEMS Bauelement während der Herstellung des integrierten Schaltkreises oder Chips getestet werden.

Bei Ausführungsbeispielen kann das zumindest eine MEMS Bauelement am Ende der Herstellung des integrierten Schaltkreises oder Chips getestet werden.

Bei Ausführungsbeispielen kann die Testvorrichtung zumindest in einem dem zumindest einen MEMS Bauelement benachbarten Bereich zumindest teilweise akustisch durchlässig sein, wobei der zumindest eine Schallsensor benachbart zu dem zumindest teilweise akustisch durchlässigen Bereich der Testvorrichtung angeordnet sein kann.

Bei Ausführungsbeispielen kann das zumindest eine MEMS Bauelement eine Gruppe von MEMS Bauelementen sein, wobei die Testvorrichtung zumindest in der Gruppe von MEMS Bauelementen benachbarten Bereichen zumindest teilweise akustisch durchlässig ist, wobei der zumindest eine Schallsensor benachbart zu den zumindest teilweise akustisch durchlässigen Bereichen der Testvorrichtung angeordnet ist.

Die Erfindung umfasst auch ein Verfahren zum akustischen Testen von zumindest einem MEMS Bauelement, wobei das Verfahren aufweist: Bereitstellen des zumindest einen MEMS Bauelements, Bereitstellen einer ersten Testvorrichtung und Kontaktieren einer ersten Seite des zumindest einen MEMS Bauelements mit der ersten Testvorrichtung, Bereitstellen einer zweiten Testvorrichtung und Kontaktieren einer der ersten Seite gegenüberliegenden zweiten Seite des zumindest einen MEMS Bauelements mit der zweiten Testvorrichtung, wobei die zweite Testvorrichtung zumindest einen Schallsensor aufweist, Anregen des zumindest eines MEMS Bauelements zu einer akustischen Schwingung, wobei das zumindest eine MEMS Bauelement über die erste Testvorrichtung angeregt wird, Erfassen der akustischen Schwingung des zumindest einen MEMS Bauelements mit dem zumindest einem Schallsensor, Auswerten der mit dem zumindest einen Schallsensor erfassten akustischen Schwingung des zumindest einen MEMS Bauelements, um das zumindest eine MEMS Bauelement auf eine Soll-Funktionsfähigkeit hin zu testen.

Bei Ausführungsbeispielen kann die zweite Testvorrichtung einen Träger für den Wafer aufweisen, wobei der Träger zumindest in einem dem zumindest einen MEMS Bauelement benachbarten Bereich zumindest teilweise akustisch durchlässig ist, und wobei der zumindest eine Schallsensor benachbart zu den zumindest teilweise akustisch durchlässigen Bereichen des Trägers angeordnet ist.

Bei Ausführungsbeispielen kann das zumindest eine MEMS Bauelement eine Gruppe von MEMS Bauelementen sein, wobei der Träger zumindest in der Gruppe von MEMS Bauelementen benachbarten Bereichen zumindest teilweise akustisch durchlässig ist, wobei der zumindest eine Schallsensor benachbart zu den zumindest teilweise akustisch durchlässigen Bereichen des Trägers angeordnet ist.

Bei Ausführungsbeispielen kann das zumindest eine MEMS Bauelement eine Gruppe von MEMS Bauelementen sein, wobei die Gruppe von MEMS Bauelementen zu akustischen Schwingungen angeregt wird, wobei die akustischen Schwingungen der Gruppe von MEMS Bauelementen mit dem zumindest einen Schallsensor erfasst werden.

Bei Ausführungsbeispielen kann der zumindest eine Schallsensor genau ein Schallsensor sein, der der Gruppe von MEMS Bauelementen zugeordnet ist.

Bei Ausführungsbeispielen kann der zumindest eine Schallsensor genau ein Schallsensorarray umfassen, das der Gruppe von MEMS Bauelementen zugeordnet ist.

Bei Ausführungsbeispielen kann der zumindest eine Schallsensor eine Mehrzahl von Schallsensoren umfassen, wobei jeweils ein Schallsensor der Mehrzahl von Schallsensoren einem MEMS Bauelement der Gruppe von MEMS Bauelementen zugeordnet ist.

Bei Ausführungsbeispielen kann der zumindest eine Schallsensor eine Mehrzahl von Schallsensorarrays umfassen, wobei jeweils ein Schallsensorarray der Mehrzahl von Schallsensorarrays einem MEMS Bauelement der Gruppe von MEMS Bauelementen zugeordnet ist.

Bei Ausführungsbeispielen können die Mehrzahl von Schallsensoren oder Schallsensorarrays gegeneinander akustisch abgeschirmt sein.

Bei Ausführungsbeispielen können die MEMS Bauelemente der Gruppe von MEMS Bauelementen gegeneinander akustisch abgeschirmt sein.

Bei Ausführungsbeispielen kann die Gruppe von MEMS Bauelementen gleichzeitig mit unterschiedlichen Signalen angeregt werden, die sich in der Frequenz nicht überlappen.

Bei Ausführungsbeispielen kann die Gruppe von MEMS Bauelementen gleichzeitig mit unterschiedlichen Signalen angeregt werden, die sich in der Frequenz überlappen.

Bei Ausführungsbeispielen kann die Gruppe von MEMS Bauelementen nacheinander mit dem gleichen Signal angeregt werden.

Bei Ausführungsbeispielen kann die Gruppe von MEMS Bauelementen gleichzeitig angeregt werden.

Bei Ausführungsbeispielen kann das zumindest eine MEMS Bauelement ein MEMS Lautsprecher, ein MEMS Mikrofon, eine MEMS Pumpe, ein MEMS Antrieb, ein MEMS Getriebe oder eine medizinische Testvorrichtung auf Grundlage von MEMS sein.

Bei Ausführungsbeispielen kann der zumindest eine Schallsensor ein Mikrofon oder ein Körperschallsensor sein.

Die Erfindung umfasst auch eine Testvorrichtung zum akustischen Testen von zumindest einem MEMS Bauelement einer Mehrzahl von auf einem Wafer angeordneten MEMS Bauelementen, wobei die Testvorrichtung ausgebildet ist, um zumindest ein MEMS Bauelement der Mehrzahl von auf dem Wafer angeordneten MEMS Bauelementen zu kontaktieren, wobei die Testvorrichtung ausgebildet ist, um das zumindest eine MEMS Bauelement zu einer akustischen Schwingung anzuregen, wobei die Testvorrichtung zumindest einen Schallsensor aufweist, der ausgebildet ist, um die akustische Schwingung des zumindest einen MEMS Bauelements zu erfassen, wobei die Testvorrichtung ausgebildet ist, um zumindest ein Signal bereitzustellen, das von der von dem Schallsensor erfassten akustische Schwingung des zumindest einen MEMS Bauelements abhängig ist, wobei die Testvorrichtung ein Prüfkopf, Teil eines Prüfkopfes oder eine Testkarte ist.

Die Erfindung umfasst auch eine Vorrichtung zum akustischen Testen von zumindest einem MEMS Bauelement einer Mehrzahl von auf einem Wafer angeordneten MEMS Bauelementen, wobei die Vorrichtung eine erste Testvorrichtung und eine zweite Testvorrichtung aufweist, wobei die erste Testvorrichtung ausgebildet ist, um eine erste Seite des zumindest einen MEMS Bauelements der Mehrzahl von auf dem Wafer angeordneten MEMS Bauelementen zu kontaktieren, wobei die erste Testvorrichtung ausgebildet ist, um das zumindest eine MEMS Bauelement zu einer akustischen Schwingung anzuregen, wobei die zweite Testvorrichtung ausgebildet ist, um eine der ersten Seite gegenüberliegenden zweiten Seite des zumindest einen MEMS Bauelements zu kontaktieren, wobei die zweite Testvorrichtung zumindest einen Schallsensor aufweist, der ausgebildet ist, um die akustische Schwingung des zumindest einen MEMS Bauelements zu erfassen, wobei die Vorrichtung ausgebildet ist, um die mit dem zumindest einen Schallsensor erfasste akustische Schwingung des zumindest einen MEMS Bauelements auszuwerten, um das zumindest eine MEMS Bauelement auf eine Soll-Funktionsfähigkeit hin zu testen.

Ausführungsbeispiele werden bezugnehmend auf die beiliegenden Figuren näher beschrieben. Es zeigen:
- Fig. 1: ein Flussdiagramm eines Verfahrens zum akustischen Testen von zumindest einem MEMS Bauelement einer Mehrzahl von MEMS Bauelementen, gemäß einem Ausführungsbeispiel der vorliegenden Erfindung,
- Fig. 2: eine schematische Ansicht einer Vorrichtung zum akustischen Testen zumindest eines MEMS Bauelements einer Mehrzahl von MEMS Bauelementen auf Waferebene, gemäß einem Ausführungsbeispiel,
- Fig. 3: eine schematische Ansicht einer Vorrichtung zum akustischen Testen eines MEMS Bauelements einer Mehrzahl von MEMS Bauelementen auf Waferebene unter Verwendung eines Schallsensors, gemäß einem Ausführungsbeispiel,
- Fig. 4: eine schematische Ansicht einer Vorrichtung zum akustischen Testen eines MEMS Bauelements einer Mehrzahl von MEMS Bauelementen auf Waferebene unter Verwendung eines Schallsensorarrays, gemäß einem Ausführungsbeispiel,
- Fig. 5: eine schematische Ansicht einer Vorrichtung zum akustischen Testen einer Gruppe von MEMS Bauelementen einer Mehrzahl von MEMS Bauelementen auf Waferebene unter Verwendung eines Schallsensors pro MEMS Bauelement der Gruppe von MEMS Bauelementen, gemäß einem Ausführungsbeispiel,
- Fig. 6: eine schematische Ansicht einer Vorrichtung zum akustischen Testen einer Gruppe von MEMS Bauelementen einer Mehrzahl von MEMS Bauelementen auf Waferebene unter Verwendung eines Schallsensorarrays pro MEMS Bauelement der Gruppe von MEMS Bauelementen, gemäß einem Ausführungsbeispiel,
- Fig. 7: eine schematische Ansicht einer Vorrichtung zum akustischen Testen einer Gruppe von MEMS Bauelementen einer Mehrzahl von MEMS Bauelementen auf Waferebene unter Verwendung eines Schallsensors für die Gruppe von MEMS Bauelementen, gemäß einem Ausführungsbeispiel,
- Fig. 8: eine schematische Ansicht einer Vorrichtung zum akustischen Testen einer Gruppe von MEMS Bauelementen einer Mehrzahl von MEMS Bauelementen auf Waferebene unter Verwendung eines Schallsensorarrays für die Gruppe von MEMS Bauelementen, gemäß einem Ausführungsbeispiel,
- Fig. 9: eine schematische Ansicht einer Vorrichtung zum akustischen Testen eines MEMS Bauelements einer Mehrzahl von MEMS Bauelementen auf Waferebene unter Verwendung eines Schallsensors, gemäß einem Ausführungsbeispiel,
- Fig. 10: eine schematische Ansicht einer Vorrichtung zum akustischen Testen eines MEMS Bauelements einer Mehrzahl von MEMS Bauelementen auf Waferebene unter Verwendung eines Schallsensorarrays, gemäß einem Ausführungsbeispiel,
- Fig. 11: eine schematische Ansicht einer Vorrichtung zum akustischen Testen einer Gruppe von MEMS Bauelementen einer Mehrzahl von MEMS Bauelementen auf Waferebene unter Verwendung eines Schallsensors pro MEMS Bauelement der Gruppe von MEMS Bauelementen, gemäß einem Ausführungsbeispiel,
- Fig. 12: eine schematische Ansicht einer Vorrichtung zum akustischen Testen einer Gruppe von MEMS Bauelementen einer Mehrzahl von MEMS Bauelementen auf Waferebene unter Verwendung eines Schallsensorarrays pro MEMS Bauelement der Gruppe von MEMS Bauelementen, gemäß einem Ausführungsbeispiel,
- Fig. 13: eine schematische Ansicht einer Vorrichtung zum akustischen Testen einer Gruppe von MEMS Bauelementen einer Mehrzahl von MEMS Bauelementen auf Waferebene unter Verwendung eines Schallsensors für die Gruppe von MEMS Bauelementen, gemäß einem Ausführungsbeispiel,
- Fig. 14: eine schematische Ansicht einer Vorrichtung zum akustischen Testen einer Gruppe von MEMS Bauelementen einer Mehrzahl von MEMS Bauelementen auf Waferebene unter Verwendung eines Schallsensorarrays für die Gruppe von MEMS Bauelementen, gemäß einem Ausführungsbeispiel,
- Fig. 15: eine schematische Ansicht eines Wafer-Testers mit einem Prüfkopf, bei dem die in den Fig. 3 bis 14 beschriebenen Ausführungsbeispiele zum Einsatz kommen können,
- Fig. 16: eine schematische Ansicht einer Vorrichtung zum akustischen Testen zumindest eines MEMS Bauelements nach einem Einformen/Verkapseln des zumindest einen MEMS Bauelements, gemäß einem Ausführungsbeispiel, und
- Fig. 17: eine schematische Ansicht einer akustischen Überprüfung zumindest eines MEMS

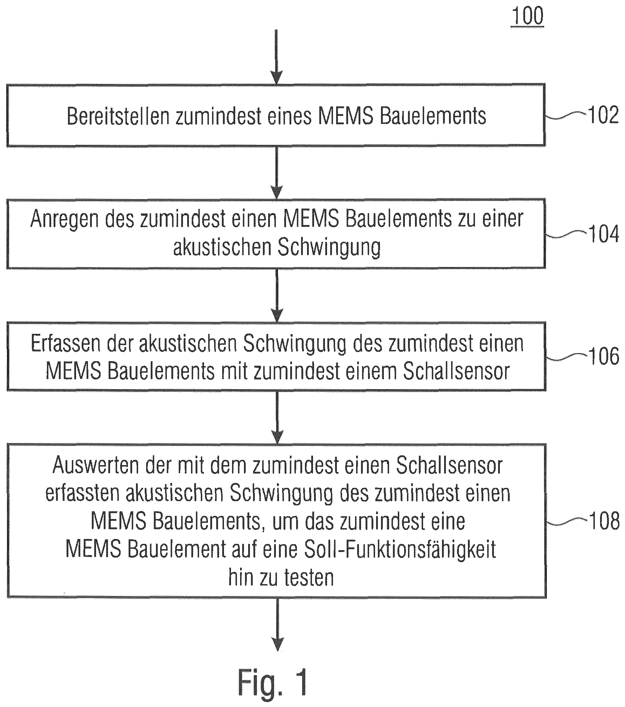

Bauelements in der Produktionslinie und am Ende der Produktionslinie. Fig. 1 zeigt nicht alle Merkmale der beanspruchten Verfahren. Die weiteren Figuren zeigen jedoch Ausführungsbeispiele, die zur beanspruchten Erfindung gehören.

In der nachfolgenden Beschreibung der Ausführungsbeispiele werden in den Figuren gleiche oder gleichwirkende Elemente mit dem gleichen Bezugszeichen versehen, so dass deren Beschreibung untereinander austauschbar ist.

Fig. 1 zeigt ein Flussdiagramm eines Verfahrens 100 zum akustischen Testen von zumindest einem MEMS Bauelement einer Mehrzahl von MEMS Bauelementen.

Das Verfahren 100 umfasst einen Schritt 102 des Bereitstellens zumindest eines MEMS Bauelements. Ferner umfasst das Verfahren 100 einen Schritt 104 des Anregens des zumindest einen MEMS Bauelements zu einer akustischen Schwingung. Ferner umfasst das Verfahren 100 einen Schritt 106 des Erfassens der akustischen Schwingung des zumindest einen MEMS Bauelements mit zumindest einem Schallsensor. Ferner umfasst das Verfahren 100 einen Schritt 108 des Auswertens der mit dem zumindest einen Schallsensor erfassten akustischen Schwingung des zumindest einen MEMS Bauelements, um das zumindest eine MEMS Bauelement auf eine Soll-Funktionsfähigkeit hin zu testen.

Bei Ausführungsbeispielen kann in dem Schritt 102 ein Wafer mit einer Mehrzahl von MEMS Bauelementen bereitgestellt werden, wobei in dem Schritt 104 zumindest ein MEMS Bauelement der Mehrzahl von MEMS Bauelementen zu einer akustischen Schwingung angeregt wird. Natürlich können in dem Schritt 104 auch mehrere (z. B. eine echte Teilmenge) oder alle der Mehrzahl von MEMS Bauelementen zu einer akustischen Schwingung angeregt werden, z. B. nacheinander, gruppenweise oder gleichzeitig. Somit ist es möglich, zumindest eines, mehrere oder alle der Mehrzahl von MEMS Bauelementen auf Waferebene vor einer Vereinzelung (engl. Dicing) der Mehrzahl von MEMS Bauelementen zu testen, z. B. auf eine Soll-Funktionsfähigkeit hin.

Natürlich können bei Ausführungsbeispielen in dem Schritt 102 auch einzelne oder mehrere bereits vereinzelte MEMS Bauelemente bereitgestellt und in dem Schritt 104 zu einer akustischen Schwingung angeregt werden, um diese auf eine Soll-Funktionsfähigkeit hin zu testen, z. B. vor und/oder nach einer Verkapselung (engl. Packaging) derselben.

Ferner kann bei Ausführungsbeispielen in dem Schritt 102 ein Teilprodukt oder ein Endprodukt mit zumindest einem MEMS Bauelement bereitgestellt und in dem Schritt 104 zu einer akustischen Schwingung angeregt werden, um dieses auf eine Soll-Funktionsfähigkeit hin zu testen. Somit ist es möglich, ein Produkt mit zumindest eine MEMS Bauelement während der Herstellung des Produktes (eng. In-Line) oder direkt nach der Herstellung des Produktes (engl. End-of-Line) zu testen.

Ausführungsbeispiele der vorliegenden Erfindung ermöglichen es somit zumindest ein MEMS Bauelement während oder nach der Herstellung desselben, vor oder nach der Verkapselung desselben, oder während oder nach einer Integration desselben in ein Produkt zu testen.

Im Folgenden werden detaillierte Ausführungsbeispiele des in Fig. 1 gezeigten Verfahrens 100 und eines Computerprogramms zur Ausführung desselben sowie einer entsprechenden Vorrichtung näher beschrieben.

Ausführungsbeispiele ermöglichen eine akustische Überprüfung (engl. Acousting Testing) und/oder akustische Charakterisierung (engl. Acoustic Characterisation) ein oder mehrerer MEMS Bauelemente, z. B. in manueller, halbautomatischer oder vollautomatischer Ausführung in den Bereichen der Halbleiterfertigung sowie in den Bereichen der Produktionslinien oder Produktwertschöpfungsketten. Ausführungsbeispiele können sich auf jeden Schritt der Wertschöpfungskette innerhalb der Produktionslinie des gesamten Produktionsprozesses oder eines Teils davon beziehen. Dabei können die jeweiligen Ausführungsbeispiele einen oder mehrere Teilaspekte umfassen, die im Folgenden kurz erläutert werden.

Bei Ausführungsbeispielen umfasst die akustische Überprüfung und/oder akustische Charakterisierung ein oder mehrerer MEMS Bauelemente im Bereich der Halbleiterfertigung u. a. Tests von Wafern (engl. Wafer Testing), beispielsweise mittels manuellen oder halbautomatischen Tests unter Verwendung eines Prüfkopfs (engl. Probe-Testing) oder vollautomatischen Tests unter Verwendung einer Testkarte für den Wafer (engl. Wafer-Probe-Card-Testing), des Weiteren Tests während der Montage (engl. Assembly-Testing), wie z. B. Tests nach dem Einformen/Verkapseln (engl. Molding/Packaging) und weiteren geeigneten oder halbleiterspezifischen Fertigungsschritten.

Bei Ausführungsbeispielen umfasst die akustische Überprüfung und/oder akustische Charakterisierung ein oder mehrerer MEMS Bauelemente im Bereich der Halbleiterfertigung Produktionslinien oder Produktschöpfungskette jegliche in der Kette möglichen Tests während der Herstellung (engl. In-Line-Testing), wie z. B. Tests während der Montage einer Leiterplatte (engl. Printed Circuit Board (PCB)-Assembly-Testing oder In-Circuit Test) oder Tests nach einem Temperaturschritt (engl. Post-Temperature-Testing) oder Stresstests (engl. Stress-Testing), sowie Tests nach der Herstellung (engl. End-of-Line-Testing) des entsprechenden Produkt- oder Produktteilschrittes.

Ausführungsbeispiele der akustischen Überprüfung und der akustischen Charakterisierung beziehen sich auf ein oder mehrere DUT (DUT = Device Under Test, dt. Prüfling), wobei sich die DUT im Bereich der Halbleiterfertigung auf die Chips oder Teilstrukturen der Chips und im Bereich der Produktionslinien auf die Produkte oder Teilprodukte mit den integrierten MEMS bezieht, welche mittels elektrischer oder mechanischer oder elektromechanischer Anregung/Aktivierung/Signale auf ihre elektrischen und/oder mechanischen Parameter kontrolliert und diese Funktionen aus Sicht definierter und/oder etablierter akustischer Tests bewertet werden.

Beispielsweise können die DUT mittels der Bewertung in vier Gruppen klassifiziert werden: 1.) DUT zeigt vollständige akustische Funktionalität (z. B. Charakterisierung grün), 2.) DUT zeigt eingeschränkte akustische Funktionalität, aber innerhalb von definierten akustischen Grenzen (z. B. Charakterisierung gelb), 3.) DUT zeigt eingeschränkte akustische Funktionalität, aber außerhalb von definierten akustischen Grenzen) (z. B. Charakterisierung orange) und 4.) DUT zeigt keine akustische Funktionalität (rot). Natürlich können bei Ausführungsbeispielen die DUT mittels der Bewertung auch in eine andere Anzahl von Gruppen klassifiziert werden, wie z. B. in zwei Gruppen: 1.) DUT funktionsfähig, und 2.) DUT nicht funktionsfähig.

Für die Bewertung der DUT können beispielsweise die im Folgenden beschriebenen akustischen Tests herangezogen werden und damit z. B. die akustischen Grenzen der DUT definiert werden.

Bei Ausführungsbeispielen kann die zeiteffiziente Erkennung einzelner defekter DUT mittels schmalbandiger, gleichzeitiger Anregung vieler DUT mit unterscheidbaren Stimuli erfolgen.

Bei Ausführungsbeispielen kann die Prüfung einzelner DUT auf den erreichten Schalldruckpegel mittels breitbandiger Anregung erfolgen.

Bei Ausführungsbeispielen können akustische Untersuchungen nach "Rub und Buzz" erfolgen. Hierbei kann gezielt nach Kratz- oder Klappergeräuschen durch zu lose oder zu feste Baugruppen gesucht werden. Beispielsweise erzeugt ein Defekt eine schmalbandige Anregung, welche sich in einem breitbandigen Spektrum äußert. Hierbei kann eine Dämmung oder Kompensation der Umgebungsgeräusche erfolgen.

Bei Ausführungsbeispielen kann der DUT in Bezug auf die Resonanzfrequenz (engl. resonance frequency), Intermodulationsverzerrung (engl. intermodulation distortion), Mehrtonverzerrung (engl. multi tone distortion), totale harmonische Verzerrung (engl. total harmonic distortion) und/oder Phasengang/Gruppenlaufzeit (engl. phase response/group delay) geprüft werden.

Bei Ausführungsbeispielen ermöglicht die Verwendung von Mikrofonarrays das Erkennen und Definieren von Abstrahlcharakteristiken einzelner DUT über z. B. Interferenzen oder dem Moiré-Effekt. Des Weiteren ist ein sehr schnelles Erkennen von defekten Bereichen auf dem Wafer möglich. Dies kann z. B. als Schnelltest dienen, um frühzeitig fatale Produktionsfehler zu erkennen. Darüber hinaus kann mittels einer Messung mit Impulsen unter Betrachtung der Laufzeit eine parallele Messung vieler DUT realisiert werden.

Bei Ausführungsbeispielen können die DUT einem akustischen Belastungstest unterzogen werden.

Bei Ausführungsbeispielen werden Vorrichtungen zur Aufnahme des MEMS oder DUT, des Prüfkopfes und/oder weitere für die akustische Überprüfung verwendeten Vorrichtungen um einen spezifischen, im Folgenden vorgestellten Aufbau erweitert und/oder ergänzt. Primärer Punkt ist das Platzieren eines Schallsensors (z. B. Mikrofons oder Körperschallsensors) oder eines Schallsensorarrays (z. B. Mikrofonarrays oder Körperschallsensorarrays) an einer akustisch sinnvollen Position, z. B. über den Schallaustrittslöchern des DUT, in der unmittelbaren Nähe eines oder mehrerer DUT. So stellt eine sinnvolle Platzierung des Testkopfes in der Halbleiterfertigung, je nach Produktionsverfahren und Testvariante der MEMS, die Position ober- oder unterhalb des Wafers oder Chips dar. Dies kann in den Produktionslinien stärker variieren und ist nur an o. g. primären Punkt geknüpft. Sekundärer Punkt ist die Sicherstellung der korrekten elektrischen, mechanischen oder elektromechanischen Ansteuerung eines oder mehrerer DUT. Sowohl in der Halbleiterfertigung als auch in den Produktionslinien ist die elektrische Ansteuerung über geeignete elektrische Kontakte, z. B. mikroskopische Nadeln, mittels dem Anwendungsszenario entsprechendem Anpressdruck gegeben. Falls benötigt, kann die mechanische Ansteuerung über geeignete Aktuatorik, z. B. Lautsprecher, erreicht werden.

Im Folgenden werden konkrete Ausführungsbeispiele der vorliegenden Erfindung beschrieben.

### 1. Testen auf Waferebene (engl. Wafer Testing)

Bei Ausführungsbeispielen kann nach der Fertigstellung des Wafers mit den noch puren MEMS-ICs (IC = Integrated Circuit, dt. integrierte Schaltkreis) eine akustische Überprüfung und/oder akustische Charakterisierung (eines oder mehrerer MEMS) durchgeführt werden.

### 1.1 Akustisches Testen mittels eines Prüfkopfs (engl, Acoustic Probe Testing)

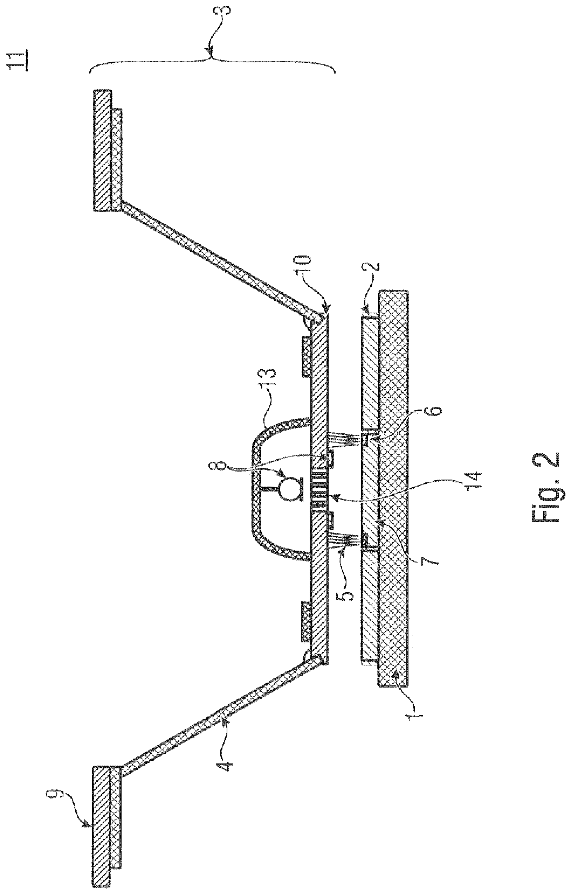

Fig. 2 zeigt eine schematische Ansicht einer Vorrichtung 11 zum akustischen Testen zumindest eines MEMS Bauelements 7 einer Mehrzahl von MEMS Bauelementen auf Waferebene, gemäß einem Ausführungsbeispiel.

Die Vorrichtung 11 kann eine Aufnahmevorrichtung 1 zum Aufnehmen (und z. B. zum Positionieren) des Wafers 2 mit der Mehrzahl von MEMS Bauelementen aufweisen. Ferner kann die Vorrichtung 11 eine Testvorrichtung 10 (z. B. eine Testkarte, Prüfkopf oder ein Teil eines Prüfkopfes) aufweisen, die ausgebildet ist, um das zumindest eine MEMS Bauelement 7 zu kontaktieren und das zumindest eine MEMS Bauelement 7 zu einer akustischen Schwingung anzuregen, z. B. mechanisch oder elektrisch, z. B. mittels Prüfnadeln 5, die die Kontakte 6 des zumindest einen MEMS Bauelements 7 kontaktieren. Die Testvorrichtung 10 kann ferner zumindest einen Schallsensor 8 (z. B. Mikrofon) aufweisen, der ausgebildet ist, um die akustische Schwingung des zumindest einen MEMS Bauelements 7 zu erfassen.

Der zumindest eine Schallsensor 8 kann hierzu benachbart zu dem zumindest einem MEMS Bauelement 7 angeordnet sein, z. B. im Bereich eines Abstrahlwinkels (z. B. Hauptabstrahlwinkels) der akustischen Schwingung des zumindest einen MEMS Bauelements 7, wie z. B. im Bereich zwischen (oder benachbart zu) den Prüfnadeln 5, die das zumindest eine MEMS Bauelement 7 kontaktieren, und/oder oberhalb eines Bereichs 14 der Testvorrichtung 10, der benachbart zu dem zumindest einem MEMS Bauelement 7 angeordnet ist, und der zumindest teilweise akustisch durchlässig ist (z. B. mittels Schalllöchern). Die Vorrichtung 11 (z. B. die Testvorrichtung 10) kann optional (z. B. sofern erforderlich) eine akustische Abschirmvorrichtung 13 (z. B. Lärmschutz) aufweisen, die ausgebildet ist, um den zumindest einen Schallsensor 8 gegen die Umgebung und/oder andere MEMS Bauelemente der Mehrzahl von MEMS Bauelementen abzuschirmen.

Wie in Fig. 2 beispielhaft gezeigt ist, kann die Testvorrichtung 10 eine Testkarte oder ein Teil eines Prüfkopfes 3 der Vorrichtung 11 sein. Der Prüfkopf 3 kann beispielsweise eine Vorrichtung 4 für die Testkarte 10 und z. B. eine Platine 9 mit Auswerteeinheiten und ggf. einer Verbindung zu einem Tester aufweisen.

Mit anderen Worten, Fig. 2 zeigt eine schematische Ansicht einer Vorrichtung zum sog. Acoustic Probe Testing (dt. akustischen Testen mittels eines Prüfkopfs), gemäß einem Ausführungsbeispiel, bei dem ein einzelnes DUT (MEMS Bauelement) mittels eines einzelnen Schallsensors (z. B. Mikrofons) getestet wird.

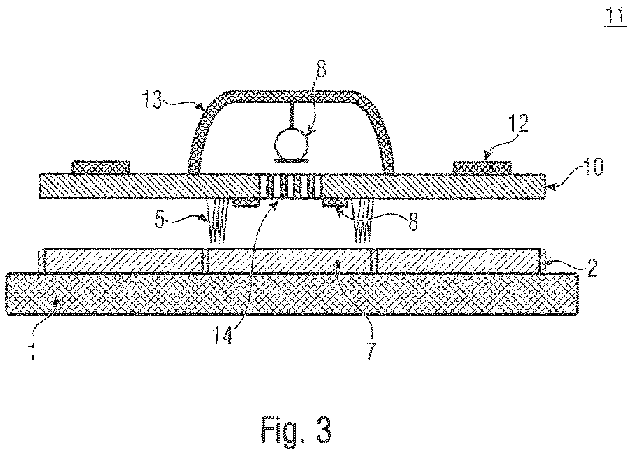

Obwohl bei dem in Fig. 2 gezeigten Ausführungsbeispiel beispielhaft davon ausgegangen wird, dass ein einzelnes MEMS Bauelement 7 der Mehrzahl von MEMS Bauelementen mittels eines einzelnen Schallsensors 8 getestet wird, sei darauf hingewiesen, dass die vorliegende Erfindung nicht auf solche Ausführungsbeispiele beschränkt ist. Vielmehr können bei Ausführungsbeispielen ein einzelnes MEMS Bauelement, eine Gruppe von MEMS Bauelementen oder aber alle MEMS Bauelemente der Mehrzahl von Bauelementen akustisch getestet werden. Hierbei kann jeweils ein Schallsensor oder Schallsensorarray pro MEMS Bauelement zum Einsatz kommen oder aber auch ein Schallsensor oder ein Schallsensorarray für mehrere MEMS Bauelemente (z. B. eine Gruppe von MEMS Bauelementen mit zumindest zwei MEMS Bauelementen) oder alle MEMS Bauelemente der Mehrzahl von MEMS Bauelementen. Diese unterschiedlichen Ausgestaltungsmöglichkeiten werden im Folgenden anhand der Fig. 3 bis 14 kurz erläutert.

Fig. 3 zeigt eine schematische Ansicht einer Vorrichtung 11 zum akustischen Testen eines MEMS Bauelements 7 einer Mehrzahl von MEMS Bauelementen auf Waferebene unter Verwendung eines Schallsensors 8, gemäß einem Ausführungsbeispiel. Analog zu dem in Fig. 2 gezeigten Ausführungsbeispiel kann die Testvorrichtung 10 einen Schallsensor 8 aufweisen, der benachbart zu dem einen MEMS Bauelement 7 der Mehrzahl von MEMS Bauelementen angeordnet ist. Mit anderen Worten, Fig. 3 zeigt einen sog. Single DUT Test (dt. Test eines einzelnen DUT (MEMS Bauelements)) mittels eines einzelnen Schallsensors (z. B. Mikrofons).

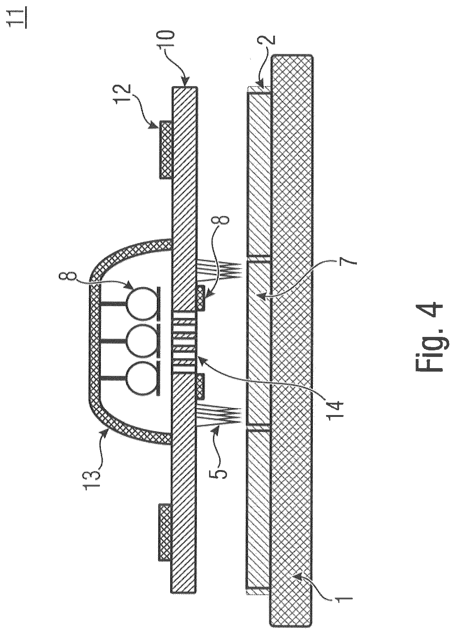

Fig. 4 zeigt eine schematische Ansicht einer Vorrichtung 11 zum akustischen Testen eines MEMS Bauelements 7 einer Mehrzahl von MEMS Bauelementen auf Waferebene unter Verwendung eines Schallsensorarrays 8, gemäß einem Ausführungsbeispiel. Im Vergleich zu dem in Fig. 3 gezeigten Ausführungsbeispiel, kann bei dem in Fig. 4 gezeigten Ausführungsbeispiel ein Schallsensorarray (z. B. Mikrofonarray) 8 anstelle eines einzelnen Schallsensors zum akustischen Testen des MEMS Bauelements 7 verwendet werden. Mit anderen Worten, Fig. 4 zeigt einen sog. Single DUT Test (dt. Test eines einzelnen DUT (MEMS Bauelements)) mittels eines Schallsensorarrays (z. B. Mikrofonarrays).

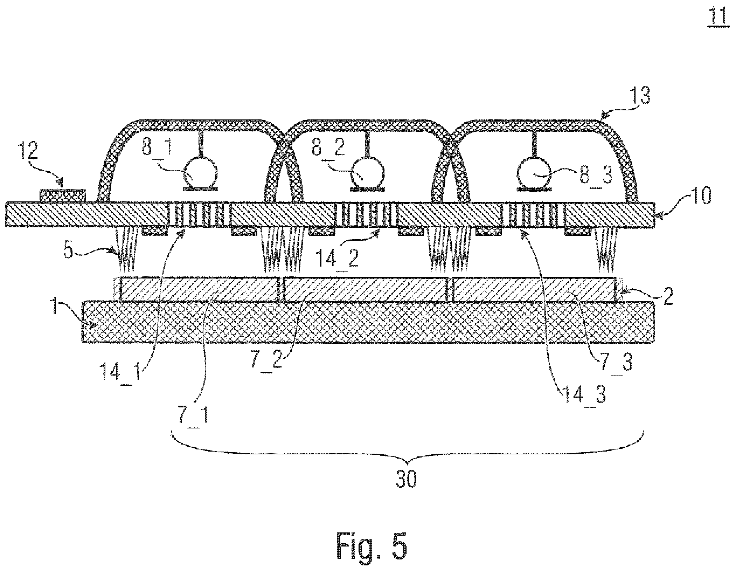

Fig. 5 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensors 8_1-8_3 pro MEMS Bauelement 7_1-7_3 der Gruppe 30 von MEMS Bauelementen 7_1-7_3, gemäß einem Ausführungsbeispiel. Im Vergleich zu dem in Fig. 3 gezeigten Ausführungsbeispiel, können bei dem in Fig. 5 gezeigten Ausführungsbeispiel eine Gruppe 30 von MEMS Bauelementen 7_1-7_3 getestet werden, wobei jedem MEMS Bauelement der Gruppe 30 von MEMS Bauelementen 7_1-7_3 jeweils ein Schallsensor 8_1-8_3 zugeordnet ist. Die Schallsensoren 8_1-8_3 können hierzu benachbart zu dem jeweiligen MEMS Bauelement 7_1-7_3 der Gruppe 30 von MEMS Bauelementen 7_1-7_3 angeordnet sein, wie z. B. jeweils im Bereich zwischen (oder benachbart zu) den Prüfnadeln, die das jeweilige MEMS Bauelement 7_1-7_3 kontaktieren, und/oder oberhalb eines jeweiligen Bereichs 14_1-14_3 der Testvorrichtung 10, der benachbart zu dem jeweiligen MEMS Bauelement 7_1-7_3 angeordnet ist, und der zumindest teilweise akustisch durchlässig ist (z. B. mittels Schalllöchern). Mit anderen Worten, Fig. 5 zeigt einen sog. Multiple DUT Test (dt. Test von mehreren DUT (MEMS Bauelementen)), mittels eines einzelnen Schallsensors (z. B. Mikrofons) pro DUT.

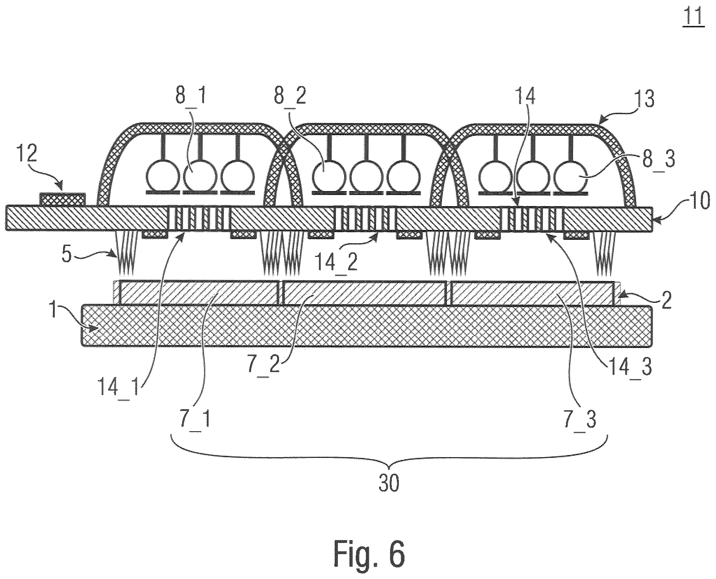

Fig. 6 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensorarrays 8_1-8_3 pro MEMS Bauelement 7_1-7_3 der Gruppe 30 von MEMS Bauelementen 7_1-7_3, gemäß einem Ausführungsbeispiel. Im Vergleich zu dem in Fig. 5 gezeigten Ausführungsbeispiel, können bei dem in Fig. 6 gezeigten Ausführungsbeispiel anstelle eines Schallsensors pro MEMS Bauelement ein Schallsensorarray 8_1-8_3 pro MEMS Bauelement 7_1-7_3 der Gruppe 30 von MEMS Bauelementen 7_1-7_3 zum Einsatz kommen. Mit anderen Worten, Fig. 6 zeigt einen sog. Multiple DUT Test (dt. Test von mehreren DUT (MEMS Bauelementen)), mittels eines Schallsensorarrays (z. B. Mikrofonarrays) pro DUT.

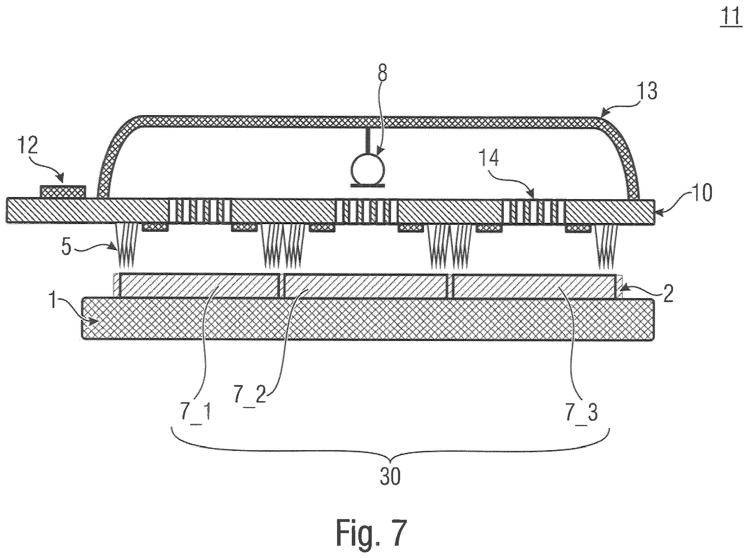

Fig. 7 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensors 8 für die Gruppe 30 von MEMS Bauelementen 7_1-7_3, gemäß einem Ausführungsbeispiel. Im Vergleich zu dem in Fig. 5 gezeigten Ausführungsbeispiel, kann bei dem in Fig. 7 gezeigten Ausführungsbeispiel anstelle eines Schallsensors pro MEMS Bauelement ein einzelner Schallsensor 8 zum akustischen Testen der Gruppe 30 von MEMS Bauelementen 7_1-7_3 zum Einsatz kommen. Mit anderen Worten, Fig. 7 zeigt einen sog. Multiple DUT Test (dt. Test von mehreren DUT (MEMS Bauelementen)), mittels eines einzelnen Schallsensors (z. B. Mikrofons).

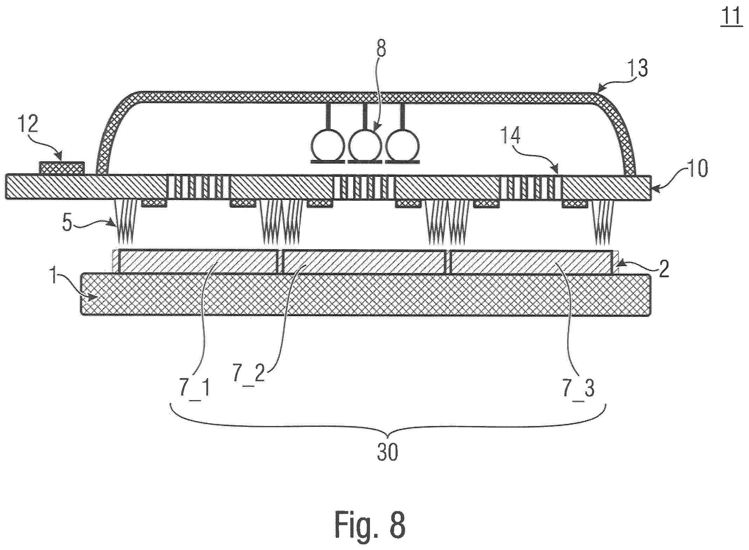

Fig. 8 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensorarrays 8 für die Gruppe 30 von MEMS Bauelementen 7_1-7_3, gemäß einem Ausführungsbeispiel. Im Vergleich zu dem in Fig. 7 gezeigten Ausführungsbeispiel, kann bei dem in Fig. 8 gezeigten Ausführungsbeispiel anstelle eines einzelnen Schallsensors ein Schallsensorarray 8 zum akustischen Testen der Gruppe 30 von MEMS Bauelementen 7_1-7_3 zum Einsatz kommen. Mit anderen Worten, Fig. 8 zeigt einen sog. Multiple DUT Test (dt. Test von mehreren DUT (MEMS Bauelementen)), mittels eines einzelnen Schallsensorarrays (z. B. Mikrofonarrays).

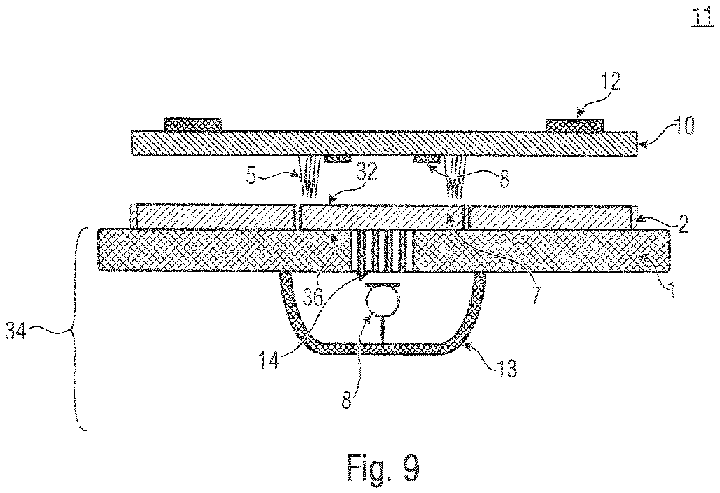

Fig. 9 zeigt eine schematische Ansicht einer Vorrichtung 11 zum akustischen Testen eines MEMS Bauelements 7 einer Mehrzahl von MEMS Bauelementen auf Waferebene unter Verwendung eines Schallsensors 8, gemäß einem Ausführungsbeispiel. Die Vorrichtung 11 kann eine erste Testvorrichtung 10 (Testkarte, Prüfkopf oder Teil eines Prüfkopfs) aufweisen, die ausgebildet ist, um eine erste Seite 32 des zumindest eine MEMS Bauelements 7 zu kontaktieren und das zumindest eine MEMS Bauelement 7 zu einer akustischen Schwingung anzuregen, z. B. mechanisch oder elektrisch, z. B. mittels Prüfnadeln 5, die die Kontakte 6 des zumindest einen MEMS Bauelements 7 kontaktieren. Die Vorrichtung 11 kann ferner eine zweite Testvorrichtung 34 aufweisen, die ausgebildet ist, um eine zweite Seite 36 des MEMS Bauelements 7 zu kontaktieren, wobei die zweite Testvorrichtung 34 zumindest einen Schallsensor 8 (z. B. Mikrofon) aufweisen kann, der ausgebildet ist, um die akustische Schwingung des zumindest einen MEMS Bauelements 7 zu erfassen.

Der zumindest eine Schallsensor 8 kann hierzu benachbart zu dem zumindest einem MEMS Bauelement 7 angeordnet sein, z. B. im Bereich eines (rückseitigen) Abstrahlwinkels (z. B. Hauptabstrahlwinkels) der akustischen Schwingung des zumindest einen MEMS Bauelements 7, wie z. B. unterhalb eines Bereichs 14 der Testvorrichtung 10, der benachbart zu dem zumindest einem MEMS Bauelement 7 angeordnet ist, und der zumindest teilweise akustisch durchlässig ist (z. B. mittels Schalllöchern). Alternativ (oder zusätzlich) kann der Schallsensor auch im Bereich der ersten Testvorrichtung 10 zwischen (oder benachbart zu) den Prüfnadeln, die das MEMS Bauelement 7 kontaktieren, angeordnet sein, wie dies in Fig. 7 angedeutet ist. Die Vorrichtung 11 (z. B. die zweite Testvorrichtung 34) kann optional (z. B. sofern erforderlich) eine akustische Abschirmvorrichtung 13 (z. B. Lärmschutz) aufweisen, die ausgebildet ist, um den zumindest einen Schallsensor 8 gegen die Umgebung und/oder andere MEMS Bauelemente der Mehrzahl von MEMS Bauelementen abzuschirmen.

Wie in Fig. 9 beispielhaft gezeigt ist, kann die zweite Testvorrichtung 34 Teil einer Aufnahmevorrichtung 1 zum Aufnehmen (und z. B. zum Positionieren) des Wafers 2 sein.

Mit anderen Worten, Fig. 9 zeigt einen sog. Single DUT Test (dt. Test eines einzelnen DUT (MEMS Bauelements)) mittels eines einzelnen Schallsensors (Mikrofons) 8.

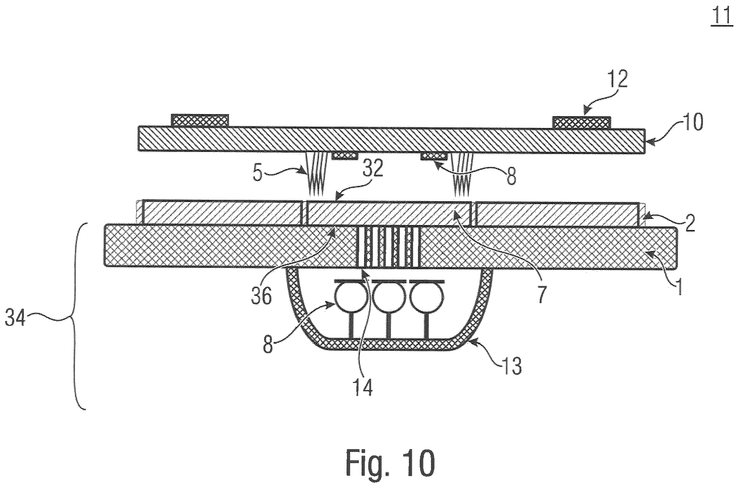

Fig. 10 zeigt eine schematische Ansicht einer Vorrichtung 11 zum akustischen Testen eines MEMS Bauelements 7 einer Mehrzahl von MEMS Bauelementen auf Waferebene unter Verwendung eines Schallsensorarrays 8, gemäß einem Ausführungsbeispiel. Im Vergleich zu dem in Fig. 9 gezeigten Ausführungsbeispiel, kann bei dem in Fig. 10 gezeigten Ausführungsbeispiel ein Schallsensorarray (z. B. Mikrofonarray) 8 anstelle eines einzelnen Schallsensors zum akustischen Testen des MEMS Bauelements 7 verwendet werden. Mit anderen Worten, Fig. 10 zeigt einen sog. Single DUT Test (dt. Test eines einzelnen DUT (MEMS Bauelements)) mittels eines Schallsensorarrays (z. B. Mikrofonarrays).

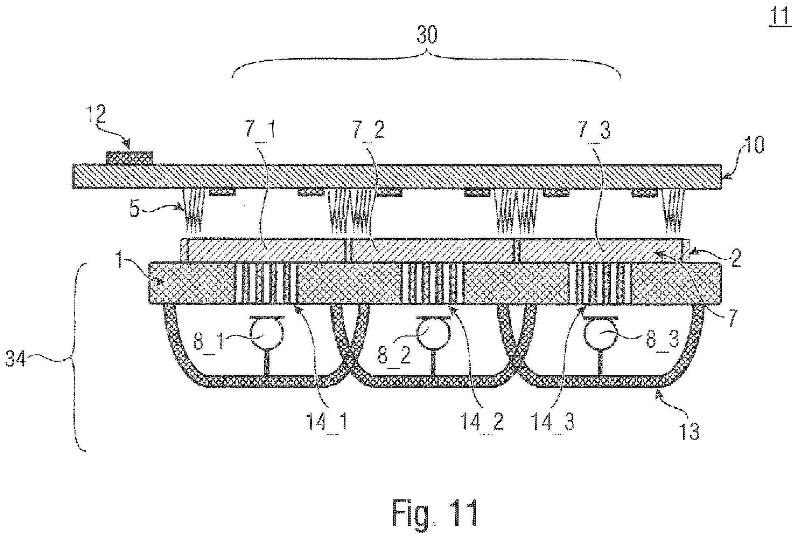

Fig. 11 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensors 8_1-8_3 pro MEMS Bauelement 7_1-7_3 der Gruppe 30 von MEMS Bauelementen 7_1-7_3, gemäß einem Ausführungsbeispiel. Im Vergleich zu dem in Fig. 10 gezeigten Ausführungsbeispiel, können bei dem in Fig. 11 gezeigten Ausführungsbeispiel eine Gruppe 30 von MEMS Bauelementen 7_1-7_3 getestet werden, wobei jedem MEMS Bauelement 7_1-7_3 der Gruppe 30 von MEMS Bauelementen 7_1-7_3 jeweils ein Schallsensor 8_1-8_3 zugeordnet ist. Die Schallsensoren 8_1-8_3 können hierzu jeweils benachbart zu dem jeweiligen MEMS Bauelement 7_1-7_3 der Gruppe 30 von MEMS Bauelementen 7_1-7_3 angeordnet sein, z. B. unterhalb eines jeweiligen Bereichs 14_1-14_3 der zweiten Testvorrichtung 34, der benachbart zu dem jeweiligen MEMS Bauelement 7_1-7_3 angeordnet ist, und der zumindest teilweise akustisch durchlässig ist (z. B. mittels Schalllöchern). Alternativ (oder zusätzlich) könnten die jeweiligen Schallsensoren auch jeweils im Bereich der ersten Testvorrichtung 10 zwischen (oder benachbart zu) den Prüfnadeln, die das jeweilige MEMS Bauelement 7_1-7_3 kontaktieren, angeordnet sein, wie dies in Fig. 11 angedeutet ist. Mit anderen Worten, Fig. 11 zeigt einen sog. Multiple DUT Test (dt. Test von mehreren DUT (MEMS Bauelementen)), mittels eines einzelnen Schallsensors (z. B. Mikrofons) pro DUT.

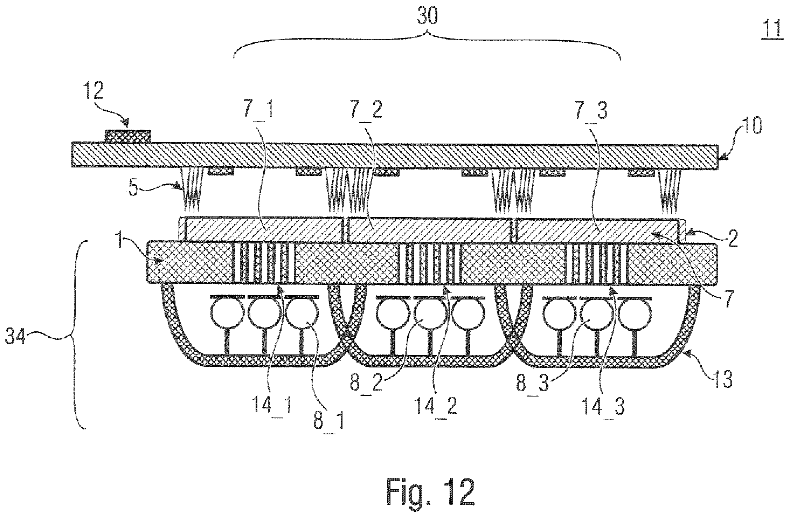

Fig. 12 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensorarrays 8_1-8_3 pro MEMS Bauelement 7_1-7_3 der Gruppe 30 von MEMS Bauelementen 7_1-7_3, gemäß einem Ausführungsbeispiel. Im Vergleich zu dem in Fig. 11 gezeigten Ausführungsbeispiel, können bei dem in Fig. 12 gezeigten Ausführungsbeispiel anstelle eines einzelnen Schallsensors pro MEMS Bauelement ein Schallsensorarray 8_1-8_3 pro MEMS Bauelement 7_1-7_3 der Gruppe 30 von MEMS Bauelementen 7_1-7_3 zum Einsatz kommen. Mit anderen Worten, Fig. 12 zeigt einen sog. Multiple DUT Test (dt. Test von mehreren DUT (MEMS Bauelementen)), mittels eines Schallsensorarrays (z. B. Mikrofonarrays) pro DUT.

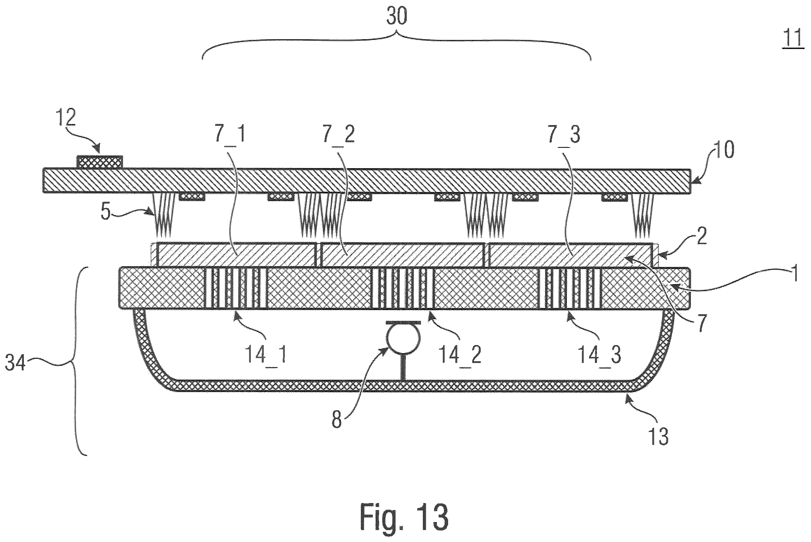

Fig. 13 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensors 8 für die Gruppe 30 von MEMS Bauelementen 7_1-7_3, gemäß einem Ausführungsbeispiel. Im Vergleich zu dem in Fig. 11 gezeigten Ausführungsbeispiel, kann bei dem in Fig. 13 gezeigten Ausführungsbeispiel anstelle eines Schallsensors pro MEMS Bauelement ein einzelner Schallsensor 8 zum akustischen Testen der Gruppe 30 von MEMS Bauelementen 7_1-7_3 zum Einsatz kommen. Mit anderen Worten, Fig. 13 zeigt einen sog. Multiple DUT Test (dt. Test von mehreren DUT (MEMS Bauelementen)), mittels eines einzelnen Schallsensors (z. B. Mikrofons).

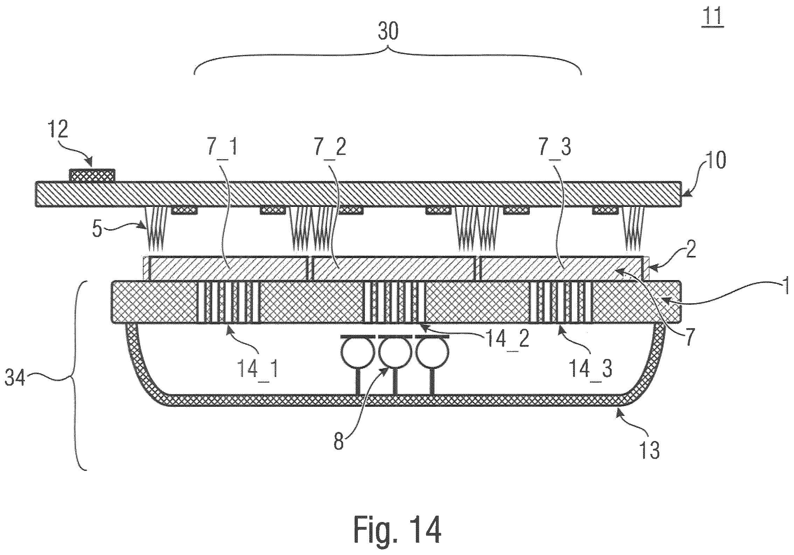

Fig. 14 zeigt eine schematische Ansicht einer Vorrichtung 11 zum akustischen Testen einer Gruppe 30 von MEMS Bauelementen 7_1-7_3 einer Mehrzahl von MEMS Bauelementen auf Waferebene unter Verwendung eines Schallsensorarrays 8 für die Gruppe 30 von MEMS Bauelementen 7_1-7_3, gemäß einem Ausführungsbeispiel. Im Vergleich zu dem in Fig. 13 gezeigten Ausführungsbeispiel, kann bei dem in Fig. 8 gezeigten Ausführungsbeispiel anstelle eines einzelnen Schallsensors ein Schallsensorarray 8 zum akustischen Testen der Gruppe 30 von MEMS Bauelementen 7_1-7_3 zum Einsatz kommen. Mit anderen Worten, Fig. 14 zeigt einen sog. Multiple DUT Test (dt. Test von mehreren DUT (MEMS Bauelementen)), mittels eines einzelnen Schallsensorarrays (z. B. Mikrofonarrays).

Bei Ausführungsbeispielen kann in manuellen oder halbautomatischen Prozessen das sogenannte Acoustic-Probe-Testing (dt. Testen mittels eines Prüfkopfs) verwendet werden. Hierbei wird der zu testende Wafer 2 in eine Vorrichtung 1 eingesetzt, welche diesen in eine definierte Position bringt. Über (abhängig vom Aufbau) dem Wafer 2 ist der Prüfkopf (Probe) 3 mit zugehöriger Vorrichtung 4 angebracht. Mittels am Prüfkopf 3 angebrachter Prüfnadeln 5 wird eine elektrische Verbindung mit den mikroskopisch kleinen Kontakten 6 der einzelnen MEMS-ICs der DUT 7 hergestellt. Innerhalb des Prüfnadel-Arrays befindet sich ein Mikrofon 8 oder ein Mikrofon-Array (siehe z. B. Fig. 3), welches nach Anwendungsfall unterschiedlich positioniert wird (siehe Fig. 3 bis 8 und Fig. 9 bis 14). Die Prüfnadeln 5 sowie das Mikrofon 8 oder das Mikrofon-Array 8 sind an dem Prüfkopf 3 an definierten Positionen angebracht. Die Positionen ergeben sich nach Art und Komplexität des zu prüfenden MEMS oder DUT 7. Der Prüfkopf 3 wird mit definierter Position und definiertem Anpressdruck an den Wafer 2 angelegt. Der Tester 9 initialisiert die elektrischen, mechanischen oder elektromechanischen Signale, fährt die o. a. akustischen Überprüfungen/Tests und erstellt eine individuelle akustische Charakterisierung des MEMS-ICs oder DUT 7, welche entscheidet, in welche Funktionsklasse der einzelne MEMS-IC oder DUT 7 eingeordnet wird.

### 1.2 Akustisches Prüfen eines Wafers mittels eines Prüfkopfs (engl. Acoustic-Wafer-Probe-Card-Testing)

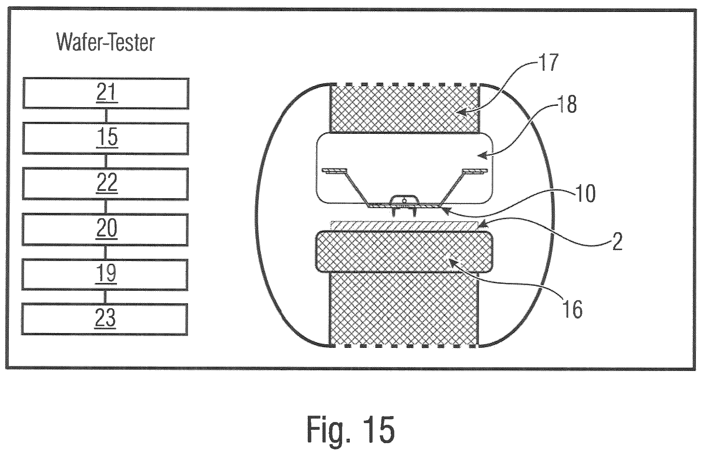

Fig. 15 zeigt eine schematische Ansicht eines Wafer-Testers (engl. Wafer Prober) mit einem Prüfkopf 17, einer Vorrichtung 18 für den Prüfkopf, einer Testkarte 10 und einer Aufnahmevorrichtung 16 für den Wafer (engl. Wafer Chuck), wobei bei dem Wafer-Tester die oben in den Fig. 3 bis 14 beschriebenen Ausführungsbeispiele zum Einsatz kommen können. Insbesondere kann die in den Fig. 3 bis 8 beschriebene Testvorrichtung 10 z. B. in Form einer Testkarte 10 zwischen Prüfkopf 17 und Wafer 2 zum Einsatz kommen, um zumindest ein MEMS Bauelement des Wafers 2 akustisch zu testen. Natürlich können auch die in den Fig. 9 bis 14 beschriebenen Testvorrichtungen 10 und 34 zum Einsatz kommen, wobei die erste Testvorrichtung 10 z. B. in Form von einer Testkarte 10 zwischen Prüfkopf 17 und Wafer 2 zum Einsatz kommen kann, und wobei die zweite Testvorrichtung 34 zwischen Wafer 2 und Aufnahmevorrichtung 16 für den Wafer (engl. Wafer Chuck) oder in Form einer (erweiterten) Aufnahmevorrichtung 16 für den Wafer (engl. Wafer Chuck) zum Einsatz kommen kann. Mit anderen Worten, Fig. 15 zeigt einen sog. Wafer-Prober (dt. Wafer-Tester) mit einem sog. Acoustic-Wafer-Probe-Testing-Prüfkopf (dt. Prüfkopf zum akustischen Testen eines Wafers).

Bei Ausführungsbeispielen kann in vollautomatischen Prozessen das sog. Acoustic-Wafer-Probe-Card-Testing (dt. akustisches Prüfen eines Wafers mittels eines Prüfkopfs) verwendet werden. Hierbei wir der zu testende Wafer 2 in eine Vorrichtung 15 auf eine Aufnahmevorrichtung 16 für den Wafer (engl. Wafer Chuck) eingesetzt. Der über dem Wafer 2 angebrachte Prüfkopf (Probe) 17, mit zugehöriger Vorrichtung 18, verfügt über eine Schnittstelle (engl. Interface) (z. B. zwischen Prüfkopf 18 und Testkarte 10) zur Testkarte (engl. Probe Card) 10, mit der der Wafer 2 geprüft wird. Die an der Testkarte (engl. Probe Card) 10 angebrachten Prüfnadeln 5 stellen eine elektrische Verbindung mit den mikroskopisch kleinen Kontakten 6 (vgl. Fig. 2) der einzelnen MEMS-ICs oder DUT 7 (vgl. Fig. 2) her. Innerhalb des Prüfnadel-Arrays befindet sich ein Mikrofon oder ein Mikrofon-Array 8 (vgl. Fig. 2), welches nach Anwendungsfall unterschiedlich positioniert wird (siehe Fig. 2 bis 14) Die Prüfnadeln sowie das Mikrofon oder das Mikrofonarray sind an definierten Positionen der Testkarte (engl. Probe Card) angebracht. Die Positionen ergeben sich nach Art und Komplexität des zu prüfenden MEMS oder DUT 7. So definiert die Größe der Testkarte (engl. Probe Card) die maximale Anzahl der möglichen MEMS oder DUT. Der Prüfkopf mit der Testkarte (engl. Probe-Card) wird mit definierter Position und definiertem Anpressdruck an den Wafer angelegt. Der Tester 19 initialisiert die elektrischen, mechanischen oder elektromechanischen Signale, fährt die o. a. akustischen Überprüfungen/Tests und erstellt eine individuelle akustische Charakterisierung des MEMS-ICs oder DUT, welche entscheidet, in welche Funktionsklasse der einzelne MEMS-IC oder DUT eingeordnet wird. Des Weiteren kann der Prober 20 die sich aktuell im Test mit dem Tester befindlichen MEMS-IC oder DUT weiteren elektrischen Tests unterziehen. Durch die Sichtscheibe 22 kann der Testvorgang überprüft werden. Der Status der Maschine ist mittels des Signallichtes 21 erkennbar. Die Farbkodierung kann hierbei beispielsweise wie folgt sein: rot - Fehler im Programmablauf oder Funktionsfehler in der Maschine, gelb - Warnung für den aktuellen Programmablauf oder Warnung für eine Maschinenfunktion, grün - Programm oder Maschinenfunktion erfolgreich beendet. Alle Teileinheiten sind mit Leitungen (z. B. Kabelsträngen) 23 verbunden.

### 2. Testen während der Montage (engl. Assembly Testing)

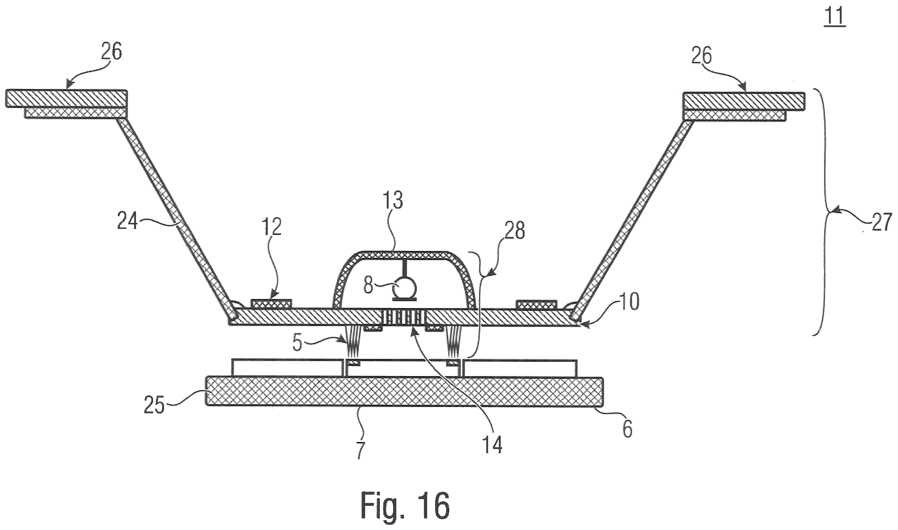

Fig. 16 zeigt eine schematische Ansicht einer Vorrichtung 11 zum akustischen Testen zumindest eines MEMS Bauelements 7 nach einem Einformen/Verkapseln des zumindest einen MEMS Bauelements, gemäß einem Ausführungsbeispiel.

Die Vorrichtung 11 kann eine Aufnahmevorrichtung 25 zum Aufnehmen (und z. B. zum Positionieren) des zumindest einen MEMS Bauelements, z. B. eines integrierten Schaltkreises mit dem zumindest einem MEMS Bauelement, aufweisen. Ferner kann die Vorrichtung 11 eine Testvorrichtung 10 (z. B. eine Testkarte oder ein Teil eines Prüfkopfes) aufweisen, die ausgebildet ist, um das zumindest eine MEMS Bauelement 7 zu kontaktieren und das zumindest eine MEMS Bauelement 7 zu einer akustischen Schwingung anzuregen, z. B. mechanisch oder elektrisch, z. B. mittels Prüfnadeln 5, die die Kontakte 6 des zumindest einen MEMS Bauelements 7 kontaktieren. Die Testvorrichtung 10 kann ferner zumindest einen Schallsensor 8 (z. B. Mikrofon) aufweisen, der ausgebildet ist, um die akustische Schwingung des zumindest einen MEMS Bauelements 7 zu erfassen.

Der zumindest eine Schallsensor 8 kann hierzu benachbart zu dem zumindest einem MEMS Bauelement 7 angeordnet sein, z. B. im Bereich eines Abstrahlwinkels (z. B. Hauptabstrahlwinkels) der akustischen Schwingung des zumindest einen MEMS Bauelements 7, wie z. B. im Bereich zwischen (oder benachbart zu) den Prüfnadeln 5, die das zumindest eine MEMS Bauelement 7 kontaktieren, und/oder oberhalb eines Bereichs 14 der Testvorrichtung 10, der benachbart zu dem zumindest einem MEMS Bauelement 7 angeordnet ist, und der zumindest teilweise akustisch durchlässig ist (z. B. mittels Schalllöchern). Die Vorrichtung 11 (z. B. die Testvorrichtung 10) kann optional (z. B. sofern erforderlich) eine akustische Abschirmvorrichtung 13 (z. B. Lärmschutz) aufweisen, die ausgebildet ist, um den zumindest einen Schallsensor 8 gegen die Umgebung und/oder andere MEMS Bauelemente der Mehrzahl von MEMS Bauelementen abzuschirmen.

Wie in Fig. 16 beispielhaft gezeigt ist, kann die Testvorrichtung 10 eine Testkarte oder ein Teil eines Prüfkopfes 27 der Vorrichtung 11 sein. Der Prüfkopf 27 kann beispielsweise eine Vorrichtung 24 für die Testkarte 10 und z. B. elektronische Komponenten 12 und ggf. einen Anschluss 26 zu Auswerteeinheiten und ggf. Verbindung zu einem Tester aufweisen.

Mit anderen Worten, Fig. 16 zeigt ein Ausführungsbeispiel für das sog. Assembly-Testing (dt. Testen während der Montage) im Rahmen des sog. Acoustic-Post-Molding/Packaging-Testing (dt. akustischen Testen nach dem Einformen/Verkapseln).

Bei Ausführungsbeispielen können nach dem Prozess des Einformens/Verkapselns (engl. Molding/Packaging), bei dem die einzelnen MEMS-(ICs) oder DUT z. B. in Epoxidharz gegossen wurden, in den nun folgenden finalen Halbleiter-Tests, die fertigen, einzeln vorliegenden MEMS-(ICs) oder DUT einer akustischen Überprüfung und einer akustischen Charakterisierung unterzogen werden - dem sog. Acoustic-Post-Molding/Packaging-Testing (dt. akustischer Test nach dem Einformen/Verkapseln). Der Prüfstand verfügt über eine von der Verkapselung (engl. Packaging) abhängige Vorrichtung 24 und 25 zur Positionierung und Fixierung des MEMS-ICs oder DUT 7. Diese nimmt den MEMS-IC oder das DUT 7 auf. Der Prüfkopf 27, bestehend aus akustischer Testeinheit 28, welche sich nach Anwendungsfall unterschiedlich aufbaut (siehe Ausführungsbeispiele der Fig. 2 bis 14), positioniert sich über dem MEMS-IC oder DUT 7 und stellt über die Kontakte 6 eine definierte Verbindung her. Der Tester 19 (siehe Fig. 15) initialisiert die elektrischen, mechanischen oder elektromechanischen Signale, fährt die o. a. akustischen Überprüfungen/Tests und erstellt eine individuelle akustische Charakterisierung des MEMS-ICs oder DUT, welche entscheidet, in welche Funktionsklasse der einzelne MEMS-IC oder DUT eingeordnet wird. Des Weiteren kann der Prober 20 (siehe Fig. 15) die sich aktuell im Test mit dem Tester befindlichen MEMS-IC oder DUT 7 weiteren elektrischen Tests unterziehen.

### 3. Produktionslinientesten (engl. Production-Line-Testing)

### 3.1 Akustisches Testen in der Produktionslinie (engl. Acoustic-In-Line-Testing)

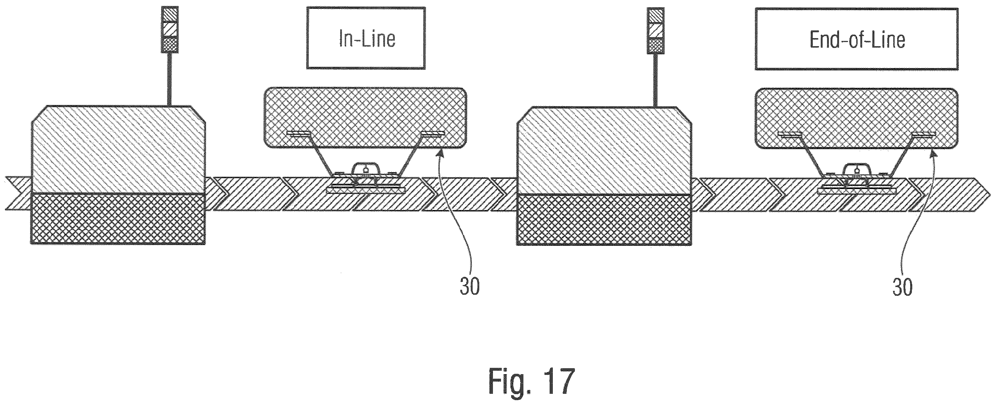

Das sog. Acoustic-In-Line-Testing (dt. akustisches Testen in der Produktionslinie) beschreibt einen Prozess, in dem zwischen den einzelnen Produktfertigungsschritten die Teilprodukte einer akustischen Überprüfung und einer akustischen Charakterisierung unterzogen werden, wie dies in Fig. 17 gezeigt ist.

Im Detail zeigt Fig. 17 eine schematische Ansicht einer akustischen Überprüfung zumindest eines MEMS Bauelements in der Produktionslinie (engl. In-Line) und am Ende der Produktionslinie (engl. End-of-Line). Mit anderen Worten, Fig. 17 zeigt Positionen für das sog. Production-Line-Testing (dt. Produktionslinientesten). Das sog. Acoustic-In-Line-Testing (dt. akustische Testen in der Produktionslinie) sowie das sog. Acousting-End-of-Line-Testing (dt. akustische Testen am Ende der Produktionslinie) mittels spezieller Aufnahmevorrichtung mit spezieller Prüfkopfvorrichtung.

Die für den Anwendungsfall spezifische Aufnahmevorrichtung 30 hält das DUT fest. Der Prüfkopf 27 (siehe Fig. 16) mit der akustische Testeinheit 28 (siehe Fig. 16) wird über dem DUT positioniert. Der Tester 19 (siehe Fig. 15) initialisiert die elektrischen, mechanischen oder elektromechanischen Signale, fährt die o. a. akustischen Überprüfungen/Tests und erstellt eine individuelle akustische Charakterisierung des DUT, welche entscheidet, ob das DUT für die weitere Produktion geeignet ist, in die Reparatur oder in den Ausschuss kommt. Ein weiterer Aspekt dieses Ausführungsbeispiels besteht in der Möglichkeit, eine Klassifizierung bis hin zur Identifizierung einzelner Chips vorzunehmen. Auf den MEMS befindliche Markierungen zur Zuordnung der Chips zu Ort und Zeitpunkt der Produktion können mit diesem Verfahren zur Wiedererkennung ergänzt werden.

### 3.2 Akustisches Testen am Produktionslinienende (engl. Acoustic-End-of-Line-Testing)

Das sog. Acoustic-End-of-Line-Testing (dt. akustische Testen am Produktionslinienende) beschreibt einen Prozess, der am Ende einer oder mehrerer Produktionsketten das Endprodukt einer akustischen Überprüfung und einer akustischen Charakterisierung unterzieht. Die für den Anwendungsfall spezifische Aufnahmevorrichtung 30 hält das DUT fest. Der Prüfkopf 27 (siehe Fig. 16) mit der akustische Testeinheit 28 (siehe Fig. 16) wird über dem DUT positioniert. Der Tester 19 (siehe Fig. 15) initialisiert die elektrischen oder mechanischen oder elektromechanischen Signale und fährt die o.a. akustischen Prüfungen/Tests und erstellt eine individuelle akustische Charakterisierung des DUT, welche entscheidet, ob das DUT den definierten Qualitätsanforderungen entspricht oder ob es in den Ausschuss kommt.

### 3.3 Betrieb der Endanwendung der MEMS

Alle zuvor als Teilaspekte genannten Verfahren kommen zum Einsatz, wenn das MEMS in der Endanwendung im laufenden Betrieb überwacht, charakterisiert und die Ansteuerung nachgeführt wird. Dazu dient die Signalverarbeitung durch ein Computerprogramm, das die Ansteuerung mithilfe der im System umgesetzten Energie vornimmt. Gespeist mit den Daten aus den zuvor genannten Ausführungsbeispielen wird hier ohne die ständige akustische Charakterisierung das Verhalten anhand der zuvor gewonnenen Parameter beurteilt und die Ansteuerung an den Zustand des MEMS angepasst.

### 4. Weitere Ausführungsbeispiele

Mithilfe der hierin beschriebenen Ausführungsbeispiele besteht die Möglichkeit, die Umwandlung der vom MEMS aufgenommenen elektrischen Energie akustisch zu bewerten. Beispielsweise kann (z. B. mittels eines Computerprogramms) in einem, mehreren oder jedem Schritt der Wertschöpfungskette eine Zuweisung zu einer Wahrscheinlichkeit vorgenommen werden, mit der das Bauelement im Rahmen vorgegebener Parameter funktionieren wird und ob eine Weiterverarbeitung aus ökonomischer Sicht sinnvoll ist. Zur Beurteilung kann die Form der Energie herangezogen werden, die aus der elektrischen Energie in thermische und akustische (z. B. Luftschall) Energie umgewandelt wurde. Bei weiteren Ausführungsbeispielen können auch elektromagnetische Wellen mithilfe der Anordnung erfasst werden.

Obwohl hierin Ausführungsbeispiele beschrieben wurden, bei denen die von dem MEMS Bauelemente erzeugten akustischen Schwingung direkt mittels eines Schallsensors erfasst wurden, sei darauf hingewiesen, dass bei Ausführungsbeispielen in der Schallführung auch akustische Filter vorgesehen sein können. Ferner sei darauf hingewiesen, dass bei der Ansteuerung Verstärker oder Signalverarbeitungseinrichtungen vorgesehen werden können. Bei Ausführungsbeispielen kann auch die Energieverteilung im MEMS erfasst und z. B. ausgewertet werden.

Bei Ausführungsbeispielen kann (z. B. mithilfe eines Computerprogramms) eine akustische Charakterisierung zur Bewertung der Signale oder Signalklassen der abgestrahlten und mittels Schallsensoren (z. B. Mikrofone) gemessenen Energie vorgenommen werden. Hierbei können Methoden der Kompensation von nichtlinearem Verhalten angewandt werden.

Es sei darauf hingewiesen, dass unter MEMS Bauelemente auch MEMS Bauelemente mit reduzierter Größe zu verstehen sind, wie z. B. NEMS Bauelemente (Nano-Electro-Mechanical Systems, dt. nanoelektromechanisches System) oder noch weiter miniaturisierte elektromechanische Systeme.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren (100) zum akustischen Testen von zumindest einem MEMS Bauelement (7) einer Mehrzahl von MEMS Bauelementen (7_1-7_3), wobei das Verfahren (100) aufweist:
Bereitstellen (102) der Mehrzahl von MEMS Bauelementen (7_1-7_3) mit dem zumindest einen MEMS Bauelement (7),
Bereitstellen einer Testvorrichtung (10) und Kontaktieren des zumindest einen MEMS Bauelements (7) mit der Testvorrichtung (10),
Anregen (104) des zumindest eines MEMS Bauelements (7) zu einer akustischen Schwingung mit der Testvorrichtung (10),
Erfassen (106) der akustischen Schwingung des zumindest einen MEMS Bauelements (7) mit zumindest einem Schallsensor (8) der Testvorrichtung (10),
Auswerten (108) der mit dem zumindest einen Schallsensor (8) erfassten akustischen Schwingung des zumindest einen MEMS Bauelements (7), um das zumindest eine MEMS Bauelement (7) auf eine Soll-Funktionsfähigkeit hin zu testen,
**dadurch gekennzeichnet, dass**
die Testvorrichtung (10) ein Prüfkopf, ein Teil eines Prüfkopfes, oder eine Testkarte ist.

2. Verfahren (100) nach Anspruch 1,
wobei das zumindest eine MEMS Bauelement (7_2) auf Waferebene vor einer Vereinzelung der Mehrzahl von MEMS Bauelementen (7_1-7_3) getestet wird,
oder wobei das zumindest eine MEMS Bauelement (7_2) nach einer Vereinzelung der Mehrzahl von MEMS Bauelementen (7_1-7_3) getestet wird.

3. Verfahren (100) nach einem der Ansprüche 1 bis 2,
wobei die Testvorrichtung (10) zumindest in einem dem zumindest einen MEMS Bauelement (7) benachbarten Bereich (14) zumindest teilweise akustisch durchlässig ist,
wobei der zumindest eine Schallsensor (8) benachbart zu dem zumindest teilweise akustisch durchlässigen Bereich (7) der Testvorrichtung (10) angeordnet ist.

4. Verfahren (100) nach Anspruch 3,
wobei das zumindest eine MEMS Bauelement (7) eine Gruppe von MEMS Bauelementen (7_1-7_3) ist,
wobei die Testvorrichtung (10) zumindest in der Gruppe von MEMS Bauelementen (7_1-7_3) benachbarten Bereichen (14_1-14_3) zumindest teilweise akustisch durchlässig ist,
wobei der zumindest eine Schallsensor (8) benachbart zu den zumindest teilweise akustisch durchlässigen Bereichen (14_1-14_3) der Testvorrichtung (10) angeordnet ist.

5. Verfahren (100) nach einem der Ansprüche 1 bis 4,
wobei das zumindest eine MEMS Bauelement (7) eine Gruppe von MEMS Bauelementen (7_1-7_3) ist,
wobei die Gruppe von MEMS Bauelementen (7_1-7_3) zu akustischen Schwingungen angeregt wird,
wobei die akustischen Schwingungen der Gruppe von MEMS Bauelementen (7_1-7_3) mit dem zumindest einen Schallsensor (8) erfasst werden.

6. Verfahren (100) nach Anspruch 5,
wobei der zumindest eine Schallsensor (8) genau ein Schallsensor ist, der der Gruppe von MEMS Bauelementen (7_1-7_3) zugeordnet ist,
oder wobei der zumindest eine Schallsensor (8) genau ein Schallsensorarray umfasst, das der Gruppe von MEMS Bauelementen (7_1-7_3) zugeordnet ist.

7. Verfahren (100) nach Anspruch 5,
wobei der zumindest eine Schallsensor (8) eine Mehrzahl von Schallsensoren (8_1-8_3) umfasst, wobei jeweils ein Schallsensor der Mehrzahl von Schallsensoren (8_1-8_3) einem MEMS Bauelement der Gruppe von MEMS Bauelementen (7_1-7_3) zugeordnet ist,
oder wobei der zumindest eine Schallsensor (8) eine Mehrzahl von Schallsensorarrays (8_1-8_3) umfasst, wobei jeweils ein Schallsensorarray der Mehrzahl von Schallsensorarrays (8_1-8_3) einem MEMS Bauelement der Gruppe von MEMS Bauelementen (7_1-7_3) zugeordnet ist.

8. Verfahren (100) nach Anspruch 7,
wobei die Mehrzahl von Schallsensoren (8_1-8_3) oder Schallsensorarrays (8_1-8_3) gegeneinander akustisch abgeschirmt sind,
und/oder wobei die MEMS Bauelemente der Gruppe von MEMS Bauelementen (7_1-7_3) gegeneinander akustisch abgeschirmt sind.

9. Verfahren (100) nach einem der Ansprüche 5 bis 8,
wobei die Gruppe von MEMS Bauelementen (7_1-7_3) gleichzeitig mit unterschiedlichen Signalen angeregt werden, die sich in der Frequenz nicht überlappen,
oder wobei die Gruppe von MEMS Bauelementen (7_1-7_3) gleichzeitig mit unterschiedlichen Signalen angeregt werden, die sich in der Frequenz überlappen,
oder wobei die Gruppe von MEMS Bauelementen (7_1-7_3) nacheinander mit dem gleichen Signal angeregt werden.

10. Verfahren (100) nach Anspruch 8,
wobei die Gruppe von MEMS Bauelementen (7_1-7_3) gleichzeitig angeregt werden.

11. Verfahren (100) nach einem der Ansprüche 1 bis 10,
wobei das zumindest eine MEMS Bauelement (8) ein MEMS Lautsprecher, ein MEMS Mikrofon, eine MEMS Pumpe, ein MEMS Antrieb, ein MEMS Getriebe oder eine medizinische Testvorrichtung auf Grundlage von MEMS ist,
und/oder wobei der zumindest eine Schallsensor (8) ein Mikrofon oder ein Körperschallsensor ist.

12. Verfahren (100) zum akustischen Testen von zumindest einem MEMS Bauelement (7), wobei das Verfahren aufweist:
Bereitstellen (102) des zumindest einen MEMS Bauelements (7),
Bereitstellen einer ersten Testvorrichtung (10) und Kontaktieren einer ersten Seite (32) des zumindest einen MEMS Bauelements (7) mit der ersten Testvorrichtung (10),
Bereitstellen einer zweiten Testvorrichtung (34), wobei die zweite Testvorrichtung (34) zumindest einen Schallsensor (8) aufweist,
Anregen (104) des zumindest eines MEMS Bauelements (7) zu einer akustischen Schwingung, wobei das zumindest eine MEMS Bauelement (7) über die erste Testvorrichtung (10) angeregt wird,
Erfassen (106) der akustischen Schwingung des zumindest einen MEMS Bauelements (7) mit dem zumindest einem Schallsensor (8),
Auswerten (108) der mit dem zumindest einen Schallsensor (8) erfassten akustischen Schwingung des zumindest einen MEMS Bauelements (7), um das zumindest eine MEMS Bauelement (7) auf eine Soll-Funktionsfähigkeit hin zu testen,
**dadurch gekennzeichnet, dass** das Verfahren ein Kontaktieren einer der ersten Seite (32) gegenüberliegenden zweiten Seite (36) des zumindest einen MEMS Bauelements (7) mit der zweiten Testvorrichtung (34) aufweist.

13. Verfahren (100) nach dem vorangehenden Anspruch,
wobei die zweite Testvorrichtung (34) einen Träger (1) für den Wafer (2) aufweist, wobei der Träger (1) zumindest in einem dem zumindest einen MEMS Bauelement (7) benachbarten Bereich (14) zumindest teilweise akustisch durchlässig ist, und
wobei der zumindest eine Schallsensor (8) benachbart zu den zumindest teilweise akustisch durchlässigen Bereichen (14) des Trägers (1) angeordnet ist.

14. Verfahren (100) nach dem vorangehenden Anspruch,
wobei das zumindest eine MEMS Bauelement (7) eine Gruppe von MEMS Bauelementen (7_1-7_3) ist,
wobei der Träger (1) zumindest in der Gruppe von MEMS Bauelementen (7_1-7_3) benachbarten Bereichen (14_1-14_3) zumindest teilweise akustisch durchlässig ist,
wobei der zumindest eine Schallsensor (8) benachbart zu den zumindest teilweise akustisch durchlässigen Bereichen (14_1-14_3) des Trägers (1) angeordnet ist.

15. Testvorrichtung (10) zum akustischen Testen von zumindest einem MEMS Bauelement (7_2) einer Mehrzahl von auf einem Wafer (2) angeordneten MEMS Bauelementen (7_1-7_3),
wobei die Testvorrichtung (10) ausgebildet ist, um zumindest ein MEMS Bauelement (7_2) der Mehrzahl von auf dem Wafer (2) angeordneten MEMS Bauelementen (7_1-7_3) zu kontaktieren,
wobei die Testvorrichtung (10) ausgebildet ist, um das zumindest eine MEMS Bauelement (7_2) zu einer akustischen Schwingung anzuregen,
wobei die Testvorrichtung zumindest einen Schallsensor (8) aufweist, der ausgebildet ist, um die akustische Schwingung des zumindest einen MEMS Bauelements (7_2) zu erfassen,
wobei die Testvorrichtung (10) ausgebildet ist, um zumindest ein Signal bereitzustellen, das von der von dem Schallsensor erfassten akustische Schwingung des zumindest einen MEMS Bauelements (7_2) abhängig ist,
**dadurch gekennzeichnet, dass**
die Testvorrichtung (10) ein Prüfkopf, Teil eines Prüfkopfes oder eine Testkarte ist.

16. Vorrichtung (11) zum akustischen Testen von zumindest einem MEMS Bauelement (7_2) einer Mehrzahl von auf einem Wafer (2) angeordneten MEMS Bauelementen (7_1-7_3),
wobei die Vorrichtung (11) eine erste Testvorrichtung (10) und eine zweite Testvorrichtung (34) aufweist,
wobei die erste Testvorrichtung (10) ausgebildet ist, um eine erste Seite (32) des zumindest einen MEMS Bauelements (7_2) der Mehrzahl von auf dem Wafer (2) angeordneten MEMS Bauelementen (7_1-7_3) zu kontaktieren,
wobei die erste Testvorrichtung (10) ausgebildet ist, um das zumindest eine MEMS Bauelement (7_2) zu einer akustischen Schwingung anzuregen,
wobei die zweite Testvorrichtung (34) zumindest einen Schallsensor (8) aufweist, der ausgebildet ist, um die akustische Schwingung des zumindest einen MEMS Bauelements (7_2) zu erfassen,
wobei die Vorrichtung (11) ausgebildet ist, um die mit dem zumindest einen Schallsensor (8) erfasste akustische Schwingung des zumindest einen MEMS Bauelements (7_2) auszuwerten, um das zumindest eine MEMS Bauelement (7_2) auf eine Soll-Funktionsfähigkeit hin zu testen, **dadurch gekennzeichnet, dass** die zweite Testvorrichtung (34) ausgebildet ist, um eine der ersten Seite (32) gegenüberliegende zweite Seite (34) des zumindest einen MEMS Bauelements (7_2) zu kontaktieren.

## Claims

1. Method (100) for acoustically testing at least one MEMS device (7) of a plurality of MEMS devices (7_1-7_3), wherein the method (100) comprises:
providing (102) the plurality of MEMS devices (7_1-7_3) with the at least one MEMS device (7),
providing a test apparatus (10) and contacting the at least one MEMS device (7) by the test apparatus (10),
exciting (104) the at least one MEMS device (7) via the test apparatus (10) to an acoustic vibration,
detecting (106) the acoustic vibration of the at least one MEMS device (7) by at least one sound sensor (8) of the test apparatus (10),
evaluating (108) the acoustic vibration of the at least one MEMS device (7), detected by the at least one sound sensor (8), to test the at least one MEMS device (7) as to an intended functionality,
**characterized in that** the test apparatus (10) is a probe head, part of a probe head or a test card.

2. Method (100) in accordance with claim 1,
wherein the at least one MEMS device (7_2) is tested on a wafer level before dicing the plurality of MEMS devices (7_1-7_3),
or wherein the at least one MEMS device (7_2) is tested after dicing the plurality of MEMS devices (7_1-7_3).

3. Method (100) in accordance with claims 1 to 2,
wherein the test apparatus (10) is at least partly acoustically transmissive at least in a region (14) adjacent to the at least one MEMS device (7),
wherein the at least one sound sensor (8) is arranged adjacent to the at least partly acoustically transmissive region (7) of the test apparatus (10).

4. Method (100) in accordance with claim 3,
wherein the at least one MEMS device (7) is a group of MEMS devices (7_1-7_3),
wherein the test apparatus (10) is at least partly acoustically transmissive at least in regions (14_1-14_3) adjacent to the group of MEMS devices (7_1-7_3),
wherein the at least one sound sensor (8) is arranged adjacent to the at least partly acoustically transmissive regions (14_1-14_3) of the test apparatus (10).

5. Method (100) in accordance with any of claims 1 to 4,
wherein the at least one MEMS device (7) is a group of MEMS devices (7_1-7_3),
wherein the group of MEMS devices (7_1-7_3) is excited to acoustic vibrations,
wherein the acoustic vibrations of the group of MEMS devices (7_1-7_3) are detected by the at least one sound sensor (8).

6. Method (100) in accordance with claim 5,
wherein the at least one sound sensor (8) is precisely one sound sensor associated to the group of MEMS devices (7_1-7_3),
or wherein the at least one sound sensor (8) comprises precisely one sound sensor array associated to the group of MEMS devices (7_1-7_3).

7. Method (100) in accordance with claim 5,
wherein the at least one sound sensor (8) comprises a plurality of sound sensors (8_1-8_3), wherein one sound sensor each of the plurality of sound sensors (8_1-8_3) is associated to a MEMS device of the group of MEMS devices (7_1-7_3),
or wherein the at least one sound sensor (8) comprises a plurality of sound sensor arrays (8_1-8_3), wherein one sound sensor array each of the plurality of sound sensor arrays (8_1-8_3) is associated to a MEMS device of the group of MEMS devices (7_1-7_3).

8. Method (100) in accordance with claim 7,
wherein the plurality of sound sensors (8_1-8_3) or sound sensors arrays (8_1-8_3) are mutually acoustically shielded,
and/or wherein the MEMS devices of the group of MEMS devices (7_1-7_3) are mutually acoustically shielded.

9. Method (100) in accordance with any one of claims 5 to 8,
wherein the group of MEMS devices (7_1-7_3) are excited simultaneously by different signals which do not overlap in frequency.
or wherein the group of MEMS devices (7_1-7_3) are excited simultaneously by different signals which overlap in frequency.
or wherein the group of MEMS devices (7_1-7_3) are excited successively by the same signal.

10. Method (100) in accordance with claim 8,
wherein the group of MEMS devices (7_1-7_3) are excited simultaneously.

11. Method (100) in accordance with any one of claims 1 to 10,
wherein the at least one MEMS device (8) is a MEMS loudspeaker, MEMS microphone, MEMS pump, MEMS drive, MEMS transmission or MEMS-based medical test apparatus.
and/or wherein the at least one sound sensor (8) is a microphone or a structure-borne sound sensor.

12. Method (100) for acoustically testing at least one MEMS device (7), wherein the method (100) comprises:
providing (102) the at least one MEMS device (7),
providing a first test apparatus (10) and contacting a first side (32) of the at least one MEMS device (7) by the first test apparatus (10),
providing a second test apparatus (34), wherein the second test apparatus (34) comprises at least one sound sensor (8),
exciting (104) the at least one MEMS device (7) to an acoustic vibration, wherein the at least one MEMS device (7) is excited via the first test apparatus (10),
detecting (106) the acoustic vibration of the at least one MEMS device (7) by the at least one sound sensor (8),
evaluating (108) the acoustic vibration of the at least one MEMS device (7), detected by the at least one sound sensor (8), to test the at least one MEMS device (7) as to an intended functionality, **characterized in that** the method comprises contacting a second side (36) of the at least one MEMS device (7) opposite the first side (32) by the second test apparatus (34).

13. Method (100) in accordance with the preceding claim,
wherein the second test apparatus (34) comprises a support (1) for the wafer (2), wherein the support (1) is at least partly acoustically transmissive at least in a region (14) adjacent to the at least one MEMS device (7), and
wherein the at least one sound sensor (8) is arranged adjacent to the at least partly acoustically transmissive regions (14) of the support (1).

14. Method (100) in accordance with the preceding claim,
wherein the at least one MEMS device (7) is a group of MEMS devices (7_1-7_3),
wherein the support (1) is at least partly acoustically transmissive at least in regions (14_1-14_3) adjacent to the group of MEMS devices (7_1-7_3),
wherein the at least one sound sensor (8) is arranged adjacent to the at least partly acoustically transmissive regions (14_1-14_3) of the support (1).

15. Test apparatus (10) for acoustically testing at least one MEMS device (7_2) of a plurality of MEMS devices (7_1-7_3) arranged on a wafer (2),
wherein the test apparatus (10) is configured to contact at least one MEMS device (7_2) of the plurality of MEMS devices (7_1-7_3) arranged on the wafer (2),
wherein the test apparatus (10) is configured to excite the at least one MEMS device (7_2) to an acoustic vibration,
wherein the test apparatus comprises at least one sound sensor (8) configured to detect the acoustic vibration of the at least one MEMS device (7_2),
wherein the test apparatus (10) is configured to provide at least one signal which is dependent on the acoustic vibration of the at least one MEMS device (7_2) detected by the sound sensor,
**characterized in that** the test apparatus (10) is a probe head, part of a probe head or a test card.

16. Apparatus (11) for acoustically testing at least one MEMS device (7_2) of a plurality of MEMS devices (7_1-7_3) arranged on a wafer (2),
wherein the apparatus (11) comprises a first test apparatus (10) and a second test apparatus (34),
wherein the first test apparatus (10) is configured to contact a first side (32) of the at least one MEMS device (7_2) of the plurality of MEMS devices (7_1-7_3) arranged on the wafer (2),
wherein the first test apparatus (10) is configured to excite the at least one MEMS device (7_2) to an acoustic vibration,
wherein the second test apparatus (34) comprises at least one sound sensor (8) configured to detect the acoustic vibration of the at least one MEMS device (7_2),
wherein the apparatus (11) is configured to evaluate the acoustic vibration of the at least one MEMS device (7_2) detected by the at least one sound sensor (8) to test the at least one MEMS device (7_2) as to an intended functionality, **characterized in that** the second test apparatus (34) is configured to contact a second side (34) of the at least one MEMS device (7_2) opposite the first side (32).

## Revendications

1. Procédé (100) destiné à tester de manière acoustique au moins un composant MEMS (7) d'une pluralité de composants MEMS (7_1-7_3), dans lequel le procédé (100) présente :
fournir (102) la pluralité de composants MEMS (7_1-7_3) avec l'au moins un composant MEMS (7),
fournir un dispositif de test (10) et mettre en contact l'au moins un composant MEMS (7) avec le dispositif de test (10),
exciter (104) l'au moins un composant MEMS (7) pour obtenir une oscillation acoustique avec le dispositif de test (10),
détecter (106) l'oscillation acoustique de l'au moins un composant MEMS (7) avec au moins un capteur de son (8) du dispositif de test (10),
évaluer (108) l'oscillation acoustique de l'au moins un composant MEMS (7) qui est détectée avec l'au moins un capteur de son (8) afin de tester une fonctionnalité de consigne de l'au moins un composant MEMS (7),
**caractérisé en ce que** le dispositif de test (10) est une tête de test, une partie d'une tête de test ou une carte de test.

2. Procédé (100) selon la revendication 1,
dans lequel l'au moins un composant MEMS (7_2) est testé sur le plan de la tranche avant la séparation de la pluralité de composants MEMS (7_1-7_3),
ou dans lequel l'au moins un composant MEMS (7_2) est testé après la séparation de la pluralité de composants MEMS (7_1-7_3).

3. Procédé (100) selon l'une des revendications 1 à 2,
dans lequel le dispositif de test (10) est au moins partiellement perméable acoustiquement au moins dans une région (14) adjacente à l'au moins un composant MEMS (7),
dans lequel l'au moins un capteur de son (8) est disposé de manière adjacente à la région (7) du dispositif de test (10) qui est au moins partiellement perméable acoustiquement.

4. Procédé (100) selon la revendication 3,
dans lequel l'au moins un composant MEMS (7) est un groupe de composants MEMS (7_1-7_3),
dans lequel le dispositif de test (10) est au moins partiellement perméable acoustiquement au moins dans des régions (14_1-14_3) adjacentes au groupe de composants MEMS (7_1-7_3),
dans lequel l'au moins un capteur de son (8) est disposé de manière adjacente aux régions (14_1-14_3) du dispositif de test (10) qui sont au moins partiellement perméables acoustiquement.

5. Procédé (100) selon l'une des revendications 1 à 4,
dans lequel l'au moins un composant MEMS (7) est un groupe de composants MEMS (7_1-7_3),
dans lequel le groupe de composants MEMS (7_1-7_3) est excité pour obtenir des oscillations acoustiques,
dans lequel les oscillations acoustiques du groupe de composants MEMS (7_1-7_3) sont détectées avec l'au moins un capteur de son (8).

6. Procédé (100) selon la revendication 5,
dans lequel l'au moins un capteur de son (8) est précisément un capteur de son qui est associé au groupe de composants MEMS (7_1-7_3),
ou dans lequel l'au moins un capteur de son (8) comprend précisément un réseau de capteurs de son qui est associé au groupe de composants MEMS (7_1-7_3).

7. Procédé (100) selon la revendication 5,
dans lequel l'au moins un capteur de son (8) comprend une pluralité de capteurs de son (8_1-8_3), dans lequel à chaque fois un capteur de son de la pluralité de capteurs de son (8_1-8_3) est associé à un composant MEMS du groupe de composants MEMS (7_1-7_3),
ou dans lequel l'au moins un capteur de son (8) comprend une pluralité de réseaux de capteurs de son (8_1-8_3), dans lequel à chaque fois un réseau de capteurs de son de la pluralité de réseaux de capteurs de son (8_1-8_3) est associé à un composant MEMS du groupe de composants MEMS (7_1-7_3).

8. Procédé (100) selon la revendication 7,
dans lequel la pluralité de capteurs de son (8_1-8_3) ou les réseaux de capteurs de son (8_1-8_3) sont protégés acoustiquement les uns des autres,
et/ou dans lequel les composants MEMS du groupe de composants MEMS (7_1-7_3) sont protégés acoustiquement les uns des autres.

9. Procédé (100) selon l'une des revendications 5 à 8,
dans lequel les composants MEMS (7_1-7_3) du groupe sont excités simultanément avec des signaux différents qui ne se chevauchent pas en fréquence,
ou dans lequel les composants MEMS (7_1-7_3) du groupe sont excités simultanément avec des signaux différents qui se chevauchent en fréquence,
ou dans lequel les composants MEMS (7_1-7_3) du groupe sont excités les uns après les autres avec le même signal.

10. Procédé (100) selon la revendication 8,
dans lequel les composants MEMS (7_1-7_3) du groupe sont excités simultanément.

11. Procédé (100) selon l'une des revendications 1 à 10,
dans lequel l'au moins un composant MEMS (8) est un haut-parleur MEMS, un microphone MEMS, une pompe MEMS, un entraînement MEMS, un engrenage MEMS ou un dispositif de test médical basé sur MEMS,
et/ou dans lequel l'au moins un capteur de son (8) est un microphone ou un capteur de son de corps.

12. Procédé (100) destiné à tester de manière acoustique au moins un composant MEMS (7), dans lequel le procédé présente :
fournir (102) l'au moins un composant MEMS (7),
fournir un premier dispositif de test (10) et mettre en contact un premier côté (32) de l'au moins un composant MEMS (7) avec le premier dispositif de test (10),
fournir un second dispositif de test (34), le second dispositif de test (34) présentant au moins un capteur de son (8),
exciter (104) l'au moins un composant MEMS (7) pour obtenir une oscillation acoustique, dans lequel l'au moins un composant MEMS (7) est excité par le biais du dispositif de test (10),
détecter (106) l'oscillation acoustique de l'au moins un composant MEMS (7) avec l'au moins un capteur de son (8),
évaluer (108) l'oscillation acoustique de l'au moins un composant MEMS (7) qui est détectée avec l'au moins un capteur de son (8) afin de tester une fonctionnalité de consigne de l'au moins un composant MEMS (7), **caractérisé en ce que** le procédé présente une mise en contact avec le second dispositif de test (34) d'un second côté (36) de l'au moins un composant MEMS (7) qui est opposé au premier côté (32).

13. Procédé (100) selon la revendication précédente,
dans lequel le second dispositif de test (34) présente un support (1) pour la tranche (2), le support (1) étant au moins partiellement perméable acoustiquement au moins dans une région (14) adjacente à l'au moins un composant MEMS (7), et
dans lequel l'au moins un capteur de son (8) est disposé de manière adjacente aux régions (14) du support (1) qui sont au moins partiellement perméables acoustiquement.

14. Procédé (100) selon la revendication précédente,
dans lequel l'au moins un composant MEMS (7) est un groupe de composants MEMS (7_1-7_3),
dans lequel le support (1) est au moins partiellement perméable acoustiquement au moins dans des régions (14_1-14_3) adjacentes au groupe de composants MEMS (7_1-7_3),
dans lequel l'au moins un capteur de son (8) est disposé de manière adjacente aux régions (14_1-14_3) du support (1) qui sont au moins partiellement perméables acoustiquement.

15. Dispositif de test (10) destiné à tester de manière acoustique au moins un composant MEMS (7_2) d'une pluralité de composants MEMS (7_1-7_3) disposés sur une tranche (2),
dans lequel le dispositif de test (10) est conçu pour mettre en contact au moins un composant MEMS (7_2) de la pluralité de composants MEMS (7_1-7_3) disposés sur la tranche (2),
dans lequel le dispositif de test (10) est conçu pour exciter l'au moins un composant MEMS (7_2) pour obtenir une oscillation acoustique,
dans lequel le dispositif de test présente au moins un capteur de son (8) qui est conçu pour détecter l'oscillation acoustique de l'au moins un composant MEMS (7_2),
dans lequel le dispositif de test (10) est conçu pour fournir au moins un signal qui est dépendant de l'oscillation acoustique de l'au moins un composant MEMS (7_2) qui est détectée par le capteur de son,
**caractérisé en ce que** le dispositif de test (10) est une tête de test, une partie d'une tête de test ou une carte de test.

16. Dispositif (11) destiné à tester de manière acoustique au moins un composant MEMS (7_2) d'une pluralité de composants MEMS (7_1-7_3) disposés sur une tranche (2),
dans lequel le dispositif (11) présente un premier dispositif de test (10) et un second dispositif de test (34),
dans lequel le premier dispositif de test (10) est conçu pour mettre en contact un premier côté (32) de l'au moins un composant MEMS (7_2) de la pluralité de composants MEMS (7_1-7_3) disposés sur la tranche (2),
dans lequel le premier dispositif de test (10) est conçu pour exciter l'au moins un composant MEMS (7_2) pour obtenir une oscillation acoustique,
dans lequel le second dispositif de test (34) présente au moins un capteur de son (8) qui est conçu pour détecter l'oscillation acoustique de l'au moins un composant MEMS (7_2),
dans lequel le dispositif (11) est conçu pour évaluer l'oscillation acoustique de l'au moins un composant MEMS (7_2) qui est détectée avec l'au moins un capteur de son (8) afin de tester une fonctionnalité de consigne de l'au moins un composant MEMS (7_2), **caractérisé en ce que** le second dispositif de test (34) est conçu pour mettre en contact un second côté (34) de l'au moins un composant MEMS (7_2) qui est opposé au premier côté (32).
